# EUROPEAN PATENT SPECIFICATION

(11) **EP 4 579 439 B1**
(45) Date of publication and mention of the grant of the patent: **02.09.2026**
(21) Application number: 24219770.5
(22) Date of filing: 13.12.2024
(51) Int. Cl.: G06F 7/544

(54) **DEVICE AND METHOD WITH MULTI-BIT OPERATION**
VORRICHTUNG UND VERFAHREN MIT MULTIBITBETRIEB
DISPOSITIF ET PROCÉDÉ À FONCTIONNEMENT MULTIBIT

(30) Priority: 29.12.2023 KR 20230197082
(43) Date of publication of application: 02.07.2025
(73) Proprietor: Samsung Electronics Co., Ltd., Suwon-si, Gyeonggi-do 16677 (KR)
(72) Inventor: Myung, Sungmeen, 16678 Suwon-si, Gyeonggi-do (KR); Yun, Seok Ju, 16678 Suwon-si, Gyeonggi-do (KR); Lee, Jaehyuk, 16678 Suwon-si, Gyeonggi-do (KR)
(74) Representative: Grünecker Patent- und Rechtsanwälte PartG mbB

(56) References cited:
- US-A1- 2022 326 910
- MYUNG SUNGMEEN ET AL: "A 14 nm MRAM-Based Multi-bit Analog In-Memory Computing With Process-Variation Calibration for 72 Macros-Based Accelerator", IEEE SOLID-STATE CIRCUITS LETTERS, vol. 7, 23 September 2024 (2024-09-23), pages 295 - 298, XP093277721, ISSN: 2573-9603, DOI: 10.1109/LSSC.2024.3465595

## Description

### BACKGROUND

### 1. Field

The following description relates to a device and method with a multi-bit operation.

### 2. Description of Related Art

A neural network operation may include a multiply-accumulate (MAC) operation which repeats multiplication and addition. At a certain node of a neural network, an operation of employing a suitable active function after performing multiplication and addition on node values of a previous layer and weights that are mapped to the node values may be performed. To perform this operation, a memory access operation of loading a suitable input and weight at a desired time and a MAC operation of performing multiplication and addition on the loaded input and weight may be repeated. In addition, an operation on an input and a weight may be required in various fields other than a neural network. Instead of processing an operation for an input and a weight by using a generally known digital computer, a method may try to improve efficiency in performing the processing of the operation for an input and a weight by using a different hardware architecture.

US 2022/326910 A1 discloses a device and method with multi-bit operation. A multi-bit cell includes: a memory storing a weight resistance corresponding to a multi-bit weight; a current source configured to apply a current to the memory to generate a weight voltage from the weight resistance; a plurality of multiplexers connected to each other in parallel and connected to the memory in series, each of the multiplexers being configured to output one signal of the weight voltage and a first fixed voltage based on a multi-bit input; and a plurality of capacitors connected to the plurality of multiplexers, respectively, each of the capacitors being configured to store a respective weight capacitance, and to generate charge data by performing an operation on the outputted signal and the weight capacitance.

### SUMMARY

The invention is claimed in the independent claims. Preferred embodiments are specified in the dependent claims.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one or more general aspects, a multi-bit operation device includes a plurality of multibit cells, and a converter configured to convert second sum data into digital data, wherein the second sum data is generated by summing pieces of first sum data output from each of the plurality of multi-bit cells, and each of the plurality of multi-bit cells comprises a memory configured to store a weight resistance corresponding to a multi-bit weight, a current source configured to apply current to the memory such that a weight voltage is generated from the weight resistance, a plurality of multiplexers connected to one another in parallel and connected to the memory in series and each configured to output a signal of one of the weight voltage and a first fixed voltage, based on a multi-bit input, a plurality of capacitors connected respectively to the plurality of multiplexers and each configured to store a separate weight capacitance and generate charge data by performing an operation on the output signal and the weight capacitance, a bit line configured to output first sum data generated by summing pieces of charge data generated by each of the plurality of capacitors, and a switch of which an end is connected to the memory and an opposite end to the end is connected to the bit line.

The multi-bit operation device may include a weight calibration module configured to measure the weight voltage by controlling the switch.

The weight calibration module may be configured to control the switch to be in a first state, input the weight voltage, which is analog data, to the converter, convert the weight voltage into digital data, and measure the weight voltage converted into the digital data.

The weight calibration module may be configured to compare the measured weight voltage with a target voltage and determine whether there is an error.

The weight calibration module may be configured to, in response to determining that there is the error, calibrate the weight resistance to the target voltage.

The memory may include resistance elements of which the number corresponds to the number of bits of the multi-bit weight and that are connected to one another in series, and the multi-bit cell may be configured to control each of the resistance elements to be on/off and adjust the weight resistance.

The plurality of multiplexers may each receive an input of 1 or 0, and a multiplexer that receives 1 may be configured to output the weight voltage and a multiplexer that receives 0 may be configured to output the first fixed voltage among the plurality of multiplexers.

In response to the first fixed voltage being output from all the plurality of multiplexers, the multi-bit cell may be configured to control the current source to be off and reduce power consumption.

The size of a second fixed voltage that is relayed to an opposite end to an end of a capacitor to which the output signal is relayed may be the same as the size of the first fixed voltage, and a capacitor that receives the first fixed voltage among the plurality of capacitors and has the same potential at both ends of the capacitor may be configured to generate 0 C charge data in response to a 0 V voltage being applied to the capacitor.

The weight resistance may be set to linearly increase as the multi-bit weight increases, and the size of the second fixed voltage may be set such that a differential value from the weight voltage is proportional to the multi-bit weight.

The multi-bit cell may include the plurality of capacitors of which the number corresponds to the number of bits of the multi-bit input, and each of the plurality of capacitors may be configured to store a weight capacitance of a value corresponding to each digit of the multi-bit input.

A value of each digit of the multi-bit input may be input to a multiplexer connected to a capacitor corresponding to the digit.

The plurality of capacitors may be configured to receive the output signal at one end and receive a second fixed voltage at an opposite end to the end, perform a differential operation on the second fixed voltage with respect to the output signal, and generate the charge data by performing a multiplication operation on a value of the differential operation and the weight capacitance.

The memory may include a first memory and a second memory configured to store different weight resistances, the multi-bit cell further may include a sign multiplexer configured to determine, based on a sign input, one memory to which the current is to be applied between the first memory and the second memory, and a weight voltage may be generated from a weight resistance stored in the determined memory.

The memory may include a first memory configured to store a first weight resistance and a second memory configured to store a second weight resistance, the current source may include a first current source configured to apply current to the first memory to generate a first weight voltage and a second current source configured to apply current to the second memory to generate a second weight voltage, and each of the plurality of multiplexers may be configured to output one signal of the first weight voltage, the second weight voltage, and the first fixed voltage, based on the multi-bit input comprising a sign input.

In one or more general aspects, a multi-bit cell includes a memory configured to store a weight resistance corresponding to a multi-bit weight, a current source configured to apply current to the memory such that a weight voltage is generated from the weight resistance, a plurality of multiplexers connected to one another in parallel and connected to the memory in series and each configured to output a signal of one of the weight voltage and a first fixed voltage, based on a multi-bit input, a plurality of capacitors connected respectively to the plurality of multiplexers and each configured to store a separate weight capacitance and generate charge data by performing an operation on the output signal and the weight capacitance, a bit line configured to output first sum data generated by summing pieces of charge data generated by each of the plurality of capacitors, and a switch of which an end is connected to the memory and an opposite end to the end is connected to the bit line.

A multi-bit operation device may include a plurality of multi-bit cells comprising the multibit cell, and a converter configured to convert second sum data into digital data, wherein the second sum data is generated by summing pieces of first sum data output from each of the plurality of multi-bit cells.

In one or more general aspects, a multi-bit operation method includes generating a weight voltage from a weight resistance by applying current to a memory in which the weight resistance corresponding to a multi-bit weight is stored, receiving a multi-bit input for a plurality of capacitors each configured to store a separate weight capacitance, relaying one signal of the weight voltage and a first fixed voltage to each of the plurality of capacitors, based on the multi-bit input, generating charge data that is stored in each of the plurality of capacitors by performing an operation on the relayed signal and the weight capacitance, outputting first sum data generated by summing pieces of charge data generated by each of the plurality of capacitors through a bit line, and controlling a switch of which an end is connected to the memory and an opposite end to the end is connected to the bit line and measuring the weight voltage.

The measuring the weight voltage may include controlling the switch to be in a first state, inputting the weight voltage, which is analog data, to a converter, converting the weight voltage into digital data, and measuring the weight voltage converted into the digital data.

The multi-bit operation method may include comparing the measured weight voltage with a target voltage and determining whether there is an error.

The multi-bit operation method may include, in response to determining that there is the error, calibrating the weight resistance to the target voltage.

Other features and aspects will be apparent from the following detailed description, the drawings, and the claims.

### BRIEF DESCRIPTION OF THE DRAWINGS

FIG. 1 illustrates an example of a mathematical model that simulates an operation of a biological neuron.
FIG. 2 illustrates an example of a neural network.
FIGS. 3A and 3B each illustrate an example of a multi-bit operation device.
FIG. 4 is a block diagram illustrating a configuration of a multi-bit cell according to one or more embodiments.
FIG. 5A is a circuit diagram illustrating a multi-bit cell according to one or more embodiments.
FIG. 5B is a diagram illustrating an occurrence of an error in a weight resistance value.
FIG. 5C is a diagram illustrating an effect of calibration according to one or more embodiments.
FIG. 6 is a circuit diagram illustrating a memory according to one or more embodiments.
FIG. 7 is a circuit diagram illustrating a multi-bit cell according to one or more embodiments in which a first fixed voltage is output from all multiplexers.
FIG. 8 is a circuit diagram illustrating a multi-bit cell according to one or more embodiments in which all capacitors store the same weight capacitance.
FIG. 9 is a circuit diagram illustrating a multi-bit cell according to one or more embodiments in which the multi-bit cell includes a plurality of memories.
FIG. 10 is a circuit diagram illustrating a multi-bit cell according to an embodiment in which the multi-bit cell includes a plurality of memories.
FIG. 11 is a flowchart illustrating an operating method of a multi-bit cell according to one or more embodiments.
FIG. 12 is a block diagram illustrating a configuration of a multi-bit operation device according to one or more embodiments.
FIG. 13 is a circuit diagram illustrating a multi-bit operation device according to one or more embodiments.
FIG. 14 is a graph illustrating a relationship between a multi-bit operation time and a digital conversion time, according to one or more embodiments.
FIG. 15 is a flowchart illustrating an operating method of a multi-bit operation device according to one or more embodiments.
FIG. 16 is a block diagram illustrating a configuration of a multi-bit operation device array according to one or more embodiments.
FIG. 17 is a block diagram illustrating an electronic system according to one or more embodiments.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Throughout the specification, when a component or element is described as "on," "connected to," "coupled to," or "joined to" another component, element, or layer, it may be directly (e.g., in contact with the other component, element, or layer) "on," "connected to," "coupled to," or "joined to" the other component element, or layer, or there may reasonably be one or more other components elements, or layers intervening therebetween. When a component or element is described as "directly on", "directly connected to," "directly coupled to," or "directly joined to" another component element, or layer, there can be no other components, elements, or layers intervening therebetween. Likewise, expressions, for example, "between" and "immediately between" and "adjacent to" and "immediately adjacent to" may also be construed as described in the foregoing.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated.

Unless otherwise defined, all terms, including technical and scientific terms, used herein have the same meaning as commonly understood by one of ordinary skill in the art to which this disclosure pertains and based on an understanding of the disclosure of the present application. It will be further understood that terms, such as those defined in commonly used dictionaries, should be interpreted as having a meaning that is consistent with their meaning in the context of the relevant art and the disclosure of the present application, and will not be interpreted in an idealized or overly formal sense unless expressly so defined herein.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment (e.g., as to what an example or embodiment may include or implement) means that at least one example or embodiment exists where such a feature is included or implemented, while all examples are not limited thereto. The use of the terms "example" or "embodiment" herein have a same meaning (e.g., the phrasing "in one example" has a same meaning as "in one embodiment", and "one or more examples" has a same meaning as "in one or more embodiments").

The examples may be implemented as various types of products, such as, for example, a personal computer (PC), a laptop computer, a tablet computer, a smartphone, a television (TV), a smart home appliance, an intelligent vehicle, a kiosk, and a wearable device. Hereinafter, examples will be described in detail with reference to the accompanying drawings. In the drawings, like reference numerals are used for like elements.

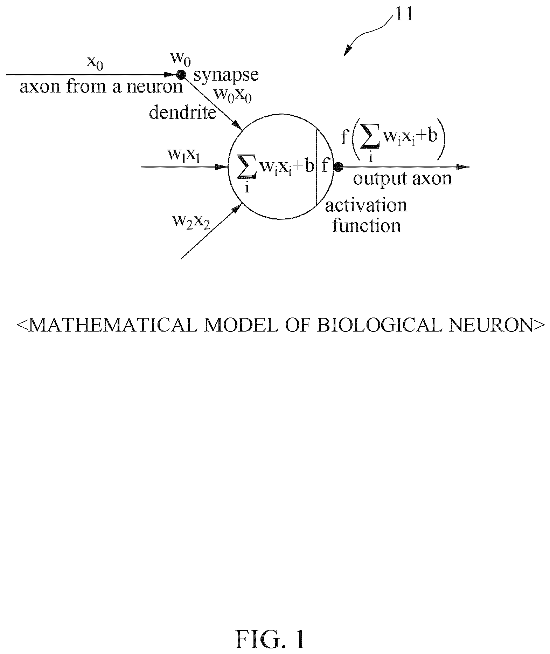

FIG. 1 illustrates an example of a node model that simulates an operation of a biological neuron.

Various attempts have continued to develop a computing device for efficiently processing a vast volume of information by simulating a biological neuron or a biological neural network that is formed of biological neurons connected to one another. The operation of a biological neuron may be simulated through a node model 11. The node model 11 may be an example of a neuromorphic operation that is executed by a hardware operation device or a hardware operation processor. The node model 11 may include a multiplication operation that multiplies a synaptic weight by information from multiple nodes, an addition operation Σ for values w₀x₀, w₁x₁, and w₂x₂ which a synaptic weight has been multiplied, and an operation of applying a characteristic function b and an activation function f to an addition operation result. The execution of a neuromorphic operation may provide a neuromorphic operation result. Here, values x₀, x₁, x₂, ..., etc. may correspond to axon values and values w₀, w₁, w₂, ..., etc. may correspond to synaptic weights.

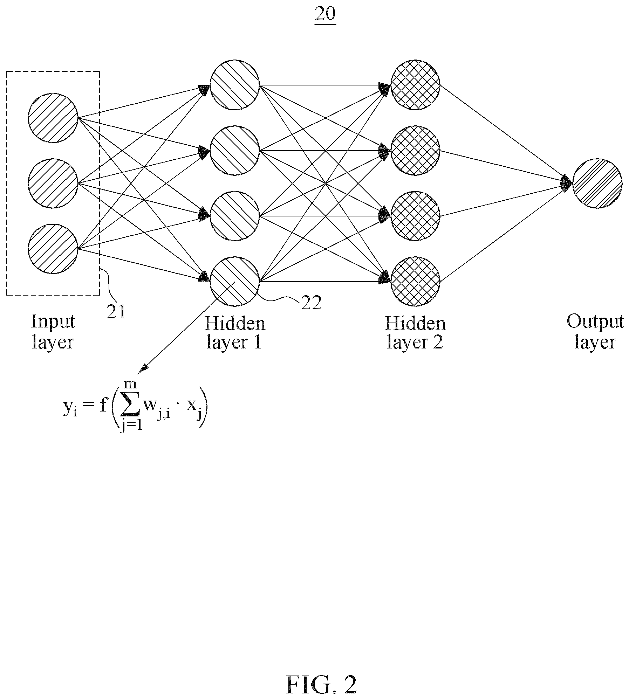

FIG. 2 illustrates an example of a neural network.

FIG. 2 illustrates an example of a neural network 20, that is, a neural network that simulates a neural network formed of biological neurons connected to one another. The neural network 20 may be an example of a deep neural network (DNN). Although the neural network 20 is illustrated as including two hidden layers for ease of description, the neural network 20 may include other numbers of hidden layers. In addition, although the neural network 20 in FIG. 2 is illustrated as including a separate input layer 21 for receiving input data, the input data may be input directly to the hidden layers.

In the neural network 20, nodes of layers except for an output layer may be connected to nodes of a subsequent layer via links for transmitting an output signal. An output of an activation function for weighted inputs of nodes included in a previous layer may be input to the nodes via the links. The weighted inputs may be obtained by multiplying weights by inputs (node values) of the nodes, the weights may be synaptic weights, and the inputs may be axon values. The weights may be referred to as parameters of the neural network 20. The activation function may include sigmoid, hyperbolic tangent (tanh), and rectified linear unit (ReLU) and may form a nonlinearity in the neural network 20.

An output of a node 22 included in this neural network 20 may be represented by Equation 1 below, for example. ${y}_{i} = f \left({\sum }_{j = 1}^{m} {w}_{j , i} {x}_{j}\right)$

Equation 1 may represent an output value yᵢ of an ith node 22 for m input values in a layer. xⱼ denotes an output value of a jth node of a previous layer. w_{j,i} denotes a weight applied to the output value of the jth node of the previous layer and the ith node 22 of the current layer. f() denotes an activation function. As shown in Equation 1, a multiply-accumulate (MAC) result of the input value xⱼ and the weight w_{j,i} may be used for the activation function. In other words, an operation (MAC operation) of multiplying and adding the appropriate input value xⱼ and weight w_{j,i} at a desired time may be repeated. Besides the above, there are various application fields implementing MAC operations, and a multi-bit operation device for processing the MAC operations in an analog area may be used for those fields.

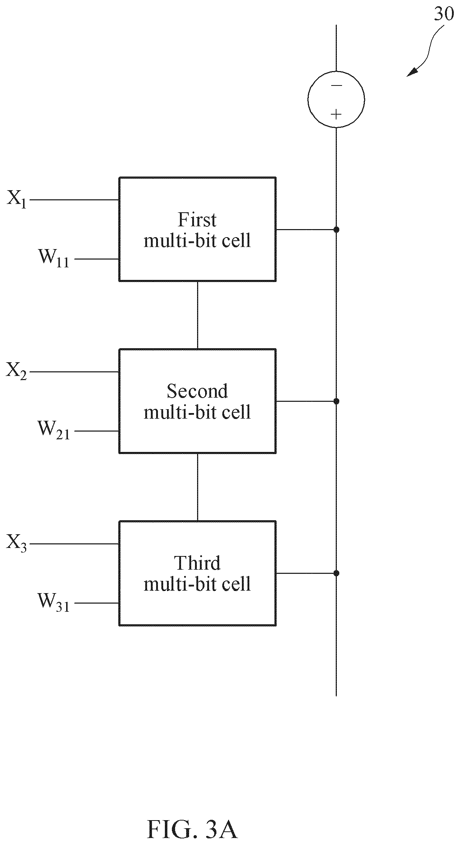

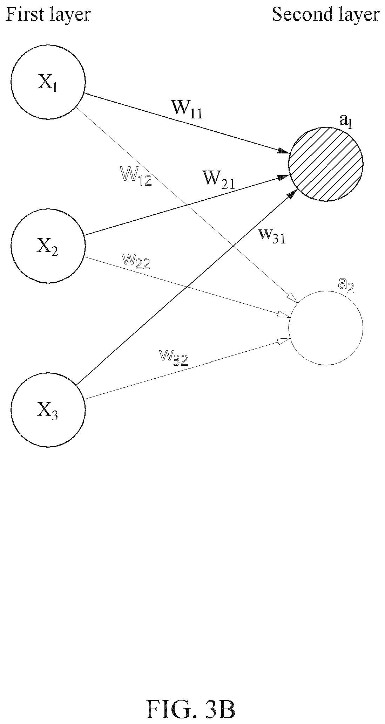

FIGS. 3A and 3B each illustrate an example of a multi-bit operation device.

Here, FIG. 3A is a diagram illustrating the architecture of a multi-bit operation device according to one or more embodiments, and FIG. 3B is a diagram illustrating a neural network including operations to be performed by the multi-bit operation device of FIG. 3A as an example.

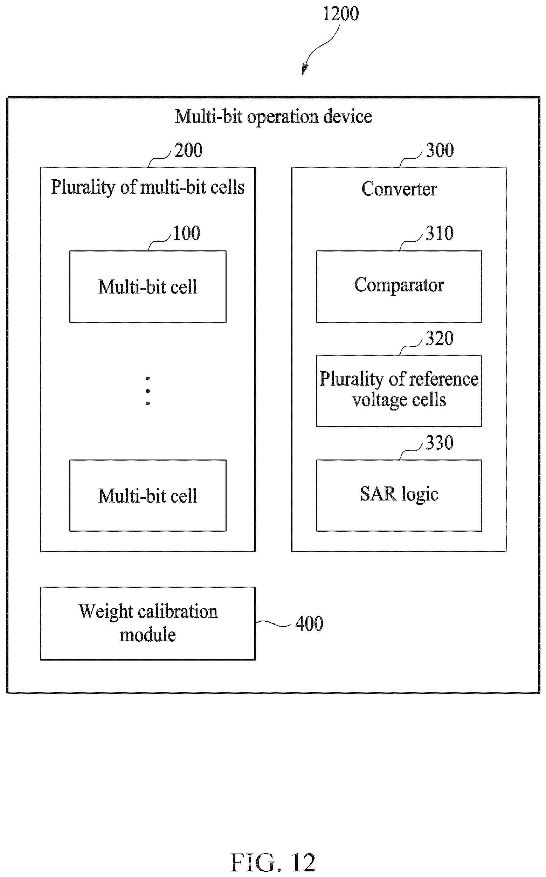

Referring to FIG. 3A, a multi-bit operation device 30 may include a plurality of multi-bit cells connected in parallel and an electric power source (e.g., voltage source or current source) that applies a voltage or a current to the multi-bit cells. Only the minimum components to describe the neural network of FIG. 3B are shown in FIG. 3A, and an example of other components that may be included in the multi-bit operation device 30 are described below with reference to FIG. 12.

The multi-bit cells included in the multi-bit operation device 30 are unit circuits that receive multi-bit inputs. The number of multi-bit cells connected in parallel is not particularly limited, and it may be a power of two, for example. However, the structure of three multi-bit cells connected in parallel is provided as an example herein for ease of description.

FIG. 3B illustrates the neural network having three nodes in a first layer and two nodes in a second layer as an example. The first layer may be one of the input layer and hidden layers of FIG. 2. The second layer may receive a value obtained by multiplying an output value of the first layer by a weight and may have a result value of inputting the received value to an activation function as a node value. This node value may be provided as an input to a next layer. For example, as shown in Equation 2 below, in a first node a₁ of the second layer, three multiplication operations that multiply an output value of the first layer by a weight corresponding to each link and an addition operation that sums the result values may be performed. The description of the activation function is omitted herein for ease of description. ${a}_{1} = {X}_{1} ⋅ {W}_{11} + {X}_{2} ⋅ {W}_{21} + {X}_{3} ⋅ {W}_{31}$

The multi-bit operation device 30 illustrated in FIG. 3A is a device that may be used for the operation of Equation 2. Referring to FIG. 3A, each of first to third multi-bit cells may have different resistance values for the electric power source. The first multi-bit cell may correspond to a first node of the first layer. Likewise, the second and third multi-bit cells may correspond respectively to second and third nodes of the first layer.

The resistance values of the multi-bit cells for the electric power source may be determined based on inputs X₁, X₂, X₃ and weights W₁₁, W₂₁, W₃₁, which are applied respectively to the multibit cells. The inputs and weights may be a multi-bit. Here, the input X₁ may refer to the output value of the first node (e.g., the first layer) or a node value thereof, which is an input applied to the first multi-bit cell. Likewise, the inputs X₂ and X₃ may refer to inputs or node values of the second and third nodes, which are inputs applied to the second and third multi-bit cells, respectively. The left '1' in the weight 'W₁₁' may refer to the first node of the first layer and the right '1' therein may refer to the first node of the second layer. The weight W₁₁ may be a weight for a link between the first node of the first layer and the first node of the second layer, which is a weight applied to the first multi-bit cell. Likewise, the weights W₂, and W₃₁ may be weights applied to the second and third multi-bit cells, respectively.

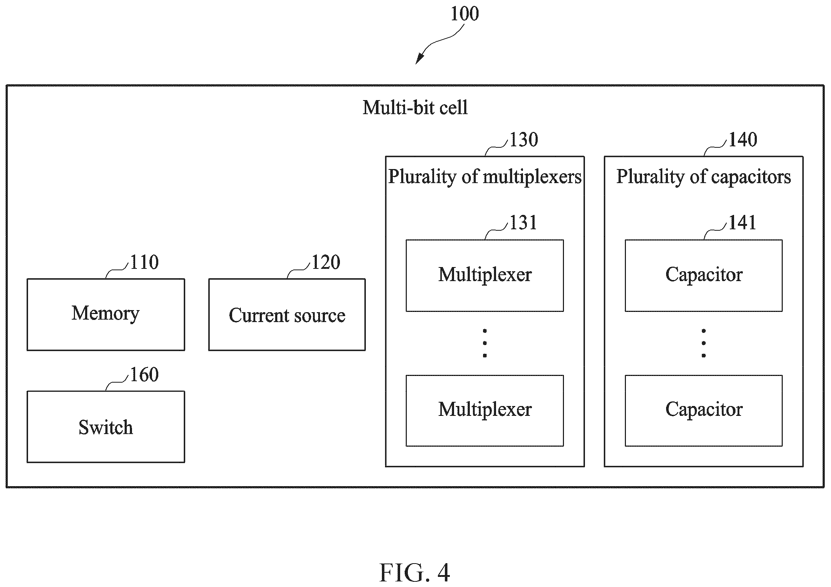

FIG. 4 is a block diagram illustrating a configuration of a multi-bit cell according to one or more embodiments.

Referring to FIG. 4, a multi-bit cell 100 may include a memory 110 (e.g., one or more memories), a current source 120, a plurality of multiplexers 130, a plurality of capacitors 140, and a switch 160. Only the components related to the present embodiments are shown in the multibit cell 100 illustrated in FIG. 4. Accordingly, it will be understood by one skilled in the art, with an understanding of the present disclosure, that the multi-bit cell 100 may further include general-purpose components other than the components illustrated in FIG. 4.

The memory 110 may store a multi-bit weight in a resistance form. The multi-bit weight stored in the memory 110 in a resistance form may be referred to as a weight resistance. When the multi-bit weight is 3 and a resistance corresponding to the multi-bit weight is 12 kΩ, the memory 110 may store the multi-bit weight that is 3 in the form of a 12 kΩ weight resistance. For example, the memory 110 may be a non-volatile memory, such as resistive random-access memory (ReRAM), phase-change memory (PCM), and/or magnetic RAM (MRAM). However, the types of the memory 110 described above are just examples, and the memory 110 may include any forms that may store resistance information without limit.

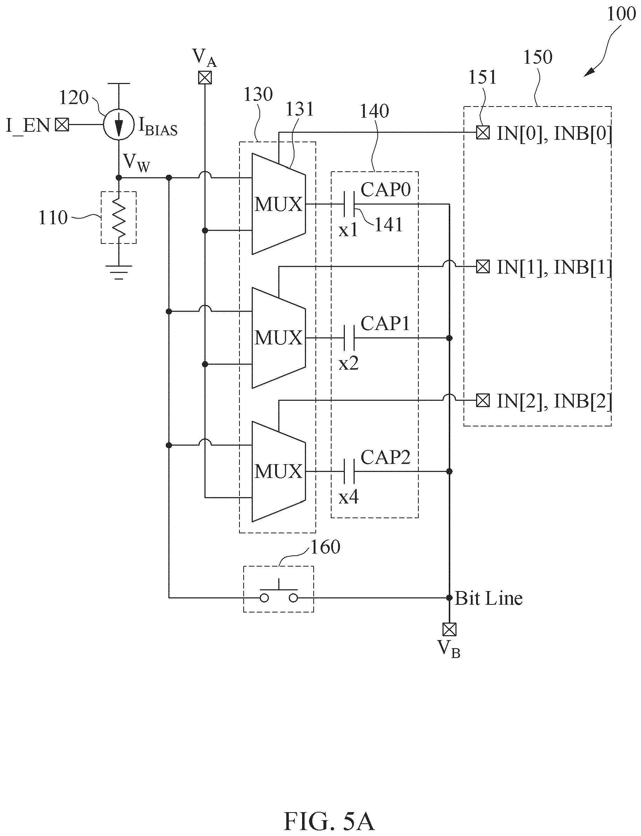

The current source 120 may apply a current to the memory 110. The current source 120 may apply a constant size of current to the memory 110 regardless of the size of voltage or resistance. For example, the current source 120 may apply a direct-current bias current, which sets an operating point of the multi-bit cell 100. Even when the size of the current applied to the memory 110 is the same, the voltage of the memory 110 may vary depending on the size of the resistance of the memory 110. As the current source 120 applies the current to the memory 110, a weight voltage may be generated from the weight resistance stored in the memory 110. The weight voltage may be generated with the current being multiplied by the weight resistance by Ohm's law. An example of the weight voltage is described in detail below with reference to FIG. 5A.

The multi-bit cell 100 may receive a multi-bit input. The multi-bit input may include a plurality of inputs, unlike a 1-bit input that is only expressed by 1 or 0. For example, the multi-bit input may be formed of values of respective digits expressing the multi-bit input. In the case of a 3-bit input, the multi-bit input may be expressed by 3'b101 and may be formed of '1' of a 2-2 digit, '0' of a 21 digit, and '1' of a 20 digit. In this case, '1', '0' and '1' may correspond respectively to values of the inputs included in the multi-bit input. The number of multi-bit weights may be the same as the number of bits of the multi-bit input.

A multiplexer 131 may receive the weight voltage by being connected to the memory 110 in series and may receive a fixed voltage through another line. The fixed voltage may be a constant size of voltage that is fixedly applied to the multiplexer 131. In addition, the multiplexer 131 may receive one of the plurality of inputs forming the multi-bit input. Based on the received input, the multiplexer 131 may output a signal of the weight voltage and the fixed voltage. For example, the multiplexer 131 may output the weight voltage when receiving 1 and may output the fixed voltage when receiving 0. An example of this is described in detail below with reference to FIG. 5A. Alternatively, the multiplexer 131 may receive a plurality of fixed voltages and may output a signal among the weight voltage and the fixed voltages, based on inputs. The multiplexer 131 may output a signal and relay the signal to a capacitor 141.

There may be the plurality of multiplexers 130 connected to one another in parallel. The plurality of multiplexers 130 may be connected to the memory 110 in series and may all receive the same signal (the weight voltage and the fixed voltage). The plurality of multiplexers 130 may receive the multi-bit input and may each output a signal of the weight voltage and the fixed voltage, based on the received multi-bit input. A signal that is output, of the weight voltage and the fixed voltage, from each multiplexer may be determined according to a value of a received input. For example, when the multi-bit input is 3'b101, a multiplexer having received '1' of the 2-2 digit and a multiplexer having received '1' of the 20 digit may output the same signal and a multiplexer having received '0' of the 21 digit may output a different signal.

The capacitor 141 may be connected to the multiplexer 131 and may receive a signal output from the multiplexer 131. The capacitor 141 may store a weight capacitance. The capacitor 141 may generate charge data by performing an operation on the received signal and the weight capacitance. An example of the operation in the capacitor 141 is described in detail below with reference to FIG. 5A.

There may be a plurality of capacitors 141 connected to one another in parallel. The capacitors 140 may be connected respectively to the plurality of multiplexers 130 in series. Accordingly, one capacitor 141 may be connected to one multiplexer 131. The plurality of capacitors 140 may each store a separate weight capacitance. The weight capacitances may be different for capacitors, may be all the same, or may only be partially different.

As described below, process variation during a semiconductor process may cause an error in a weight resistance value. The multi-bit cell 100 according to one or more embodiments may include a switch 160 to detect and correct an error in a weight resistance value.

FIG. 5A is a circuit diagram illustrating a multi-bit cell according to one or more embodiments.

Referring to FIG. 5A, the multi-bit cell 100 may include the memory 110, the current source 120, the plurality of multiplexers 130, the plurality of capacitors 140, and the switch 160. The multi-bit cell 100 may receive a multi-bit input 150, and an individual input 151 included in the multi-bit input 150 may be input to each multiplexer 131.

Only the components related to the present embodiments are shown in the circuit diagram illustrated in FIG. 5A. Accordingly, it will be understood by one skilled in the art, with an understanding of the present disclosure, that the circuit diagram may further include general-purpose components other than the components illustrated in FIG. 5A.

Referring to the circuit diagram of FIG. 5A, a weight voltage and a first fixed voltage may be input to the multiplexer 131. In addition, the multiplexer 131 may receive one input 151 forming the multi-bit input 150. The input 151 received by the multiplexer 131 may serve as a selector signal SEL for the multiplexer 131 and may output one signal of the weight voltage and the first fixed voltage from the multiplexer 131.

The signal output from the multiplexer 131 may be relayed to the capacitor 141. The signal output from the multiplexer 131 may be relayed to the left end of the capacitor 141, and the second fixed voltage may be relayed to the right end of the capacitor 141. Accordingly, a voltage having a potential difference between the signal output from the multiplexer 131 and the second fixed voltage may be applied to the capacitor 141. Hereinafter, an example of the operation method of the multi-bit input 150 and a multi-bit weight is described in detail.

The memory 110 may store a weight resistance corresponding to the multi-bit weight. A value of the weight resistance corresponding to each value of the multi-bit weight may vary. The weight resistance may be set to linearly increase as the multi-bit weight increases. For example, the weight resistance may increase by a constant difference as the multi-bit weight increases by a constant difference, like an isometric sequence. An example of the weight resistance for a 3-bit weight may be represented by Table 1 below.

**Table 1:**

| Multi-bit weight | Weight resistance (kΩ) |
|---|---|
| -7 | 7 |
| -5 | 8 |
| -3 | 9 |
| -1 | 10 |
| 1 | 11 |
| 3 | 12 |
| 5 | 13 |
| 7 | 14 |

The multi-bit cell 100 may generate a weight voltage from the weight resistance by the current source 120 applying a current to the memory 110. When the current is applied to the weight resistance stored in the memory 110, the current and the weight resistance may be multiplied according to Ohm's law, and as a result, the weight voltage may be generated. Since the current source 120 may output a constant size of current, the weight voltage may be proportional to the weight resistance. An example of the weight voltage for the 3-bit weight may be represented by Table 2 below.

**Table 2:**

| Multi-bit weight | Weight resistance (kΩ) | Current (µA) | Weight voltage (mV) |
|---|---|---|---|
| -7 | 7 | 50 | 350 |
| -5 | 8 | 50 | 400 |
| -3 | 9 | 50 | 450 |
| -1 | 10 | 50 | 500 |
| 1 | 11 | 50 | 550 |
| 3 | 12 | 50 | 600 |
| 5 | 13 | 50 | 650 |
| 7 | 14 | 50 | 700 |

The multi-bit cell 100 may receive the multi-bit input 150 by using the plurality of capacitors 140 that receive a 1-bit input 151. The number of capacitors 140 and the weight capacitance may be set to receive the multi-bit input 150.

For example, the number of capacitors 140 of the multi-bit cell 100 may correspond to the number of bits of the multi-bit input 150, and each of the capacitors 140 may store a value of the weight capacitance corresponding to each digit of the multi-bit input 150. When the multi-bit input 150 is a 3-bit input, the multi-bit input 150 may be expressed by 3'b000 to 3'b111, and respective digits of the multi-bit input 150 may be 20, 21, and 22. In this case, the multi-bit cell 100 may include three capacitors 140 and the capacitors 140 may respectively store 20 times of a unit capacitance, 21 times of the unit capacitance, and 22 times of the unit capacitance. Referring to FIG. 5A, the multi-bit input 150 that is a 3-bit input may be applied, three capacitors 140 are illustrated, and each capacitor 140 storing a capacitance weight of 1, 2, and 4 times of the unit capacitance are illustrated.

The capacitors 140 may indirectly receive the multi-bit input 150 through the plurality of multiplexers 130. As described above, the multi-bit input 150 may include the plurality of inputs, and each of the inputs may be received by a multiplexer connected to a corresponding capacitor. A value of each digit of the multi-bit input 150 may be input to a multiplexer connected to a capacitor corresponding to the value of each digit. For example, when the multi-bit input 150 is a 3-bit input, a 20-digit value of the multi-bit input 150 may be input to a capacitor CAPO that stores a capacitance weight of one time the unit capacitance, a 21-digit value of the multi-bit input 150 may be input to a capacitor CAP1 that stores a capacitance weight of 2 times the unit capacitance, and a 22-digit value of the multi-bit input 150 may be input to a capacitor CAP2 that stores a capacitance weight of 4 times the unit capacitance, indirectly. Since the value of each digit of the multi-bit input 150 may be input directly to the multiplexer, and a signal output from the multiplexer based on the input is relayed to the capacitor, the value of each digit may be input indirectly to the capacitor.

When the multi-bit input 150 is 3'b110 (or 6), 1 may be input to a multiplexer corresponding to the capacitor CAP2, 1 may be input to a multiplexer corresponding to the capacitor CAP1, and 0 may be input to a multiplexer corresponding to the capacitor CAPO. An example of a value input to a multiplexer according to a value of the 3-bit multi-bit input 150 is shown in Table 3 below.

**Table 3:**

| Multi-bit weight | MUX - CAP2(×4) | MUX - CAP1(x2) | MUX - CAP0(×1) |
|---|---|---|---|
| 4 | 1 | 0 | 0 |
| 4 | 1 | 0 | 0 |
| 2 | 0 | 1 | 0 |
| 7 | 1 | 1 | 1 |
| 2 | 0 | 1 | 0 |
| 1 | 0 | 0 | 1 |
| 0 | 0 | 0 | 0 |
| 0 | 0 | 0 | 0 |
| 1 | 0 | 0 | 1 |
| 5 | 1 | 0 | 1 |
| 0 | 0 | 0 | 0 |
| 4 | 1 | 0 | 0 |
| 1 | 0 | 0 | 1 |
| 1 | 0 | 0 | 1 |
| 6 | 1 | 1 | 0 |
| 3 | 0 | 1 | 1 |

As such, the plurality of multiplexers 130 may each receive an input of 1 or 0. A multiplexer that receives 1 among the plurality of multiplexers 130 may output the weight voltage and a multiplexer that receives 0 among the plurality of multiplexers 130 may output the first fixed voltage. However, this is just an example and may be performed vice versa or may be performed variously depending on the settings of the multiplexers. For example, the multiplexers may receive different types of an input or may determine a signal to be output based on a plurality of inputs. An example of the signal relayed to each capacitor from the plurality of multiplexers 130 according to the example of Table 3 is shown in Table 4 below.

**Table 4:**

| Multi-bit weight | MUX - CAP2(×4) | MUX - CAP1(x2) | MUX - CAP0(×1) |
|---|---|---|---|
| 4 | weight voltage | first fixed voltage | first fixed voltage |
| 4 | weight voltage | first fixed voltage | first fixed voltage |
| 2 | first fixed voltage | weight voltage | first fixed voltage |
| 7 | weight voltage | weight voltage | weight voltage |
| 2 | first fixed voltage | weight voltage | first fixed voltage |
| 1 | first fixed voltage | first fixed voltage | weight voltage |
| 0 | first fixed voltage | first fixed voltage | first fixed voltage |
| 0 | first fixed voltage | first fixed voltage | first fixed voltage |
| 1 | first fixed voltage | first fixed voltage | weight voltage |
| 5 | weight voltage | first fixed voltage | weight voltage |
| 0 | first fixed voltage | first fixed voltage | first fixed voltage |
| 4 | weight voltage | first fixed voltage | first fixed voltage |
| 1 | first fixed voltage | first fixed voltage | weight voltage |
| 1 | first fixed voltage | first fixed voltage | weight voltage |
| 6 | weight voltage | weight voltage | first fixed voltage |
| 3 | first fixed voltage | weight voltage | weight voltage |

The capacitor 141 may receive a signal output from the multiplexer 131 at one end and may receive a second fixed voltage at the opposite end to the end. The capacitor 141 may perform a differential operation on the second fixed voltage with respect to the signal output from the multiplexer 131. Accordingly, the capacitor 141 may perform a differential operation on the second fixed voltage with respect to the weight voltage or the first fixed voltage. A differential value may be a potential difference between both ends of the capacitor 141 and may be a voltage applied to the capacitor 141. For example, when the first fixed voltage is set to have the same value as the second fixed voltage, a differential value of the second fixed voltage for the first fixed voltage may be 0 V. However, the first fixed voltage and the second fixed voltage may be set to have different values depending on the structure and setting of the multi-bit cell 100. In this case, the differential value may be a value other than 0 V.

The size of the second fixed voltage may be set such that a differential value with the weight voltage is proportional to the multi-bit weight. In the example of Table 2, the second fixed voltage may be 525 mV, which is an average value of weight voltage values. A relationship between the weight voltage, the second fixed voltage, and a differential value of the second fixed voltage for the weight voltage may be summarized as shown in Table 5 below, for example.

**Table 5:**

| Multi-bit weight | Weight voltage (mV) | Second fixed voltage (mV) | Differential value (mV) |
|---|---|---|---|
| -7 | 350 | 525 | -175 |
| -5 | 400 | 525 | -125 |
| -3 | 450 | 525 | -75 |
| -1 | 500 | 525 | -25 |
| 1 | 550 | 525 | 25 |
| 3 | 600 | 525 | 75 |
| 5 | 650 | 525 | 125 |
| 7 | 700 | 525 | 175 |

As shown in Table 5, the size of the second fixed voltage may be set such that the differential value is proportional to the multi-bit weight. In the example of Table 5, the first fixed voltage may also be set equivalent to the second fixed voltage.

**Table 6:**

| Row | Multi-bit input | Multi-bit weight | Weight voltage (mV) | Differential value (mV) |
|---|---|---|---|---|
| 1 | 4 | -1 | 500 | -25 |
| 2 | 4 | -1 | 500 | -25 |
| 3 | 2 | 1 | 550 | 25 |
| 4 | 7 | 7 | 700 | 175 |
| 5 | 2 | 3 | 600 | 75 |
| 6 | 1 | -1 | 500 | -25 |
| 7 | 0 | 3 | 600 | 75 |
| 8 | 0 | -5 | 400 | -125 |
| 9 | 1 | 1 | 550 | 25 |
| 10 | 5 | 7 | 700 | 175 |
| 11 | 0 | -1 | 500 | -25 |
| 12 | 4 | -5 | 400 | -125 |
| 13 | 1 | 3 | 600 | 75 |
| 14 | 1 | 7 | 700 | 175 |
| 15 | 6 | -7 | 350 | -175 |
| 16 | 3 | 3 | 600 | 75 |

Table 6 above, for example, shows the multi-bit input 150 set for each of the plurality of multi-bit cells 100 according to the example of Table 2, the multi-bit weight, the weight voltage according to the multi-bit weight, and the differential value of the second fixed voltage for the weight voltage.

The values of the multi-bit input 150 and the multi-bit weight as shown in Table 6 are set randomly based on 3 bits and may vary. One row of Table 6 may correspond to one multi-bit cell 100. Accordingly, Table 6 shows the results of 16 multi-bit cells 100.

Since the first fixed voltage may be set equivalent to the second fixed voltage, a capacitor that receives the first fixed voltage among the capacitors 140 may have the same potential at both ends, and a potential difference may be 0 V. In this case, the capacitor may receive a 0 V voltage and may generate 0 C charge data.

Table 7 below, for example, shows a differential value operated in each capacitor of the multi-bit cells 100 according to the examples of the tables shown above, which is a potential difference at both ends of each capacitor.

**Table 7:**

| Row | Multi-bit input | Multi-bit weight | Differential value (mV) | | |
|---|---|---|---|---|---|
| | | | CAP2(×4) | CAP1(×2) | CAP0(×1) |
| 1 | 4 | -1 | -25 | 0 | 0 |
| 2 | 4 | -1 | -25 | 0 | 0 |
| 3 | 2 | 1 | 0 | 25 | 0 |
| 4 | 7 | 7 | 175 | 175 | 175 |
| 5 | 2 | 3 | 0 | 75 | 0 |
| 6 | 1 | -1 | 0 | 0 | -25 |
| 7 | 0 | 3 | 0 | 0 | 0 |
| 8 | 0 | -5 | 0 | 0 | 0 |
| 9 | 1 | 1 | 0 | 0 | 25 |
| 10 | 5 | 7 | 175 | 0 | 175 |
| 11 | 0 | -1 | 0 | 0 | 0 |
| 12 | 4 | -5 | -125 | 0 | 0 |
| 13 | 1 | 3 | 0 | 0 | 75 |
| 14 | 1 | 7 | 0 | 0 | 175 |
| 15 | 6 | -7 | -175 | -175 | 0 |
| 16 | 3 | 3 | 0 | 75 | 75 |

The capacitor 141, by multiplying the differential value by the weight capacitance, may generate charge data. In other words, the capacitor 141, by multiplying the differential value (voltage) by the weight capacitance according to operation Q=C×V, may generate the charge data.

Table 8 below, for example, shows the charge data generated in each capacitor according to the example of Table 7.

**Table 8:**

| Row | Multi-bit input | Multi-bit weight | Charge data (Q=C×V, C_{OUT}=1F) (mC) | | |
|---|---|---|---|---|---|
| | | | CAP2(×4) | CAP1(x2) | CAP0(×1) |
| 1 | 4 | -1 | -100 | 0 | 0 |
| 2 | 4 | -1 | -100 | 0 | 0 |
| 3 | 2 | 1 | 0 | 50 | 0 |
| 4 | 7 | 7 | 700 | 350 | 175 |
| 5 | 2 | 3 | 0 | 150 | 0 |
| 6 | 1 | -1 | 0 | 0 | -25 |
| 7 | 0 | 3 | 0 | 0 | 0 |
| 8 | 0 | -5 | 0 | 0 | 0 |
| 9 | 1 | 1 | 0 | 0 | 25 |
| 10 | 5 | 7 | 700 | 0 | 175 |
| 11 | 0 | -1 | 0 | 0 | 0 |
| 12 | 4 | -5 | -500 | 0 | 0 |
| 13 | 1 | 3 | 0 | 0 | 75 |
| 14 | 1 | 7 | 0 | 0 | 175 |
| 15 | 6 | -7 | -700 | -350 | 0 |
| 16 | 3 | 3 | 0 | 150 | 75 |

The multi-bit cell 100 may output first sum data generated by summing the charge data generated by each of the capacitors 140. In the example of Table 8, the multi-bit cell 100 corresponding to row 1 may output the first sum data of -100 mC, and the multi-bit cell 100 corresponding to row 4 may output the first sum data of 1,225 mC. The first sum data of each row may all be summed up and converted into a digital signal. An example of this is described below with reference to FIG. 12.

On the other hand, by comparing a multiplication result of the multi-bit input 150 and the multi-bit weight with the first sum data, an operation method of the multi-bit cell 100 may be verified. The multiplication of multi-bit input 150 of row 1 and the multi-bit weight is -4, and the multiplication of the multi-bit input 150 of row 4 and the multi-bit weight is 49. Referring to Table 5, it is confirmed that the differential value of the second fixed voltage for the weight voltage is 25 times the multi-bit input 150. Here, since the first sum data of row 1 is -4×25 mC and the first sum data of row 4 is 49×25 mC, it is confirmed that the first sum data corresponds to the multiplication results described above.

Without performing a multiplication operation on the multi-bit input 150 and the multi-bit weight directly, through the plurality of capacitors 140 that store individual capacitance weights, the multi-bit cell 100 may perform a multi-bit operation by converting the multi-bit weight into the voltage weight.

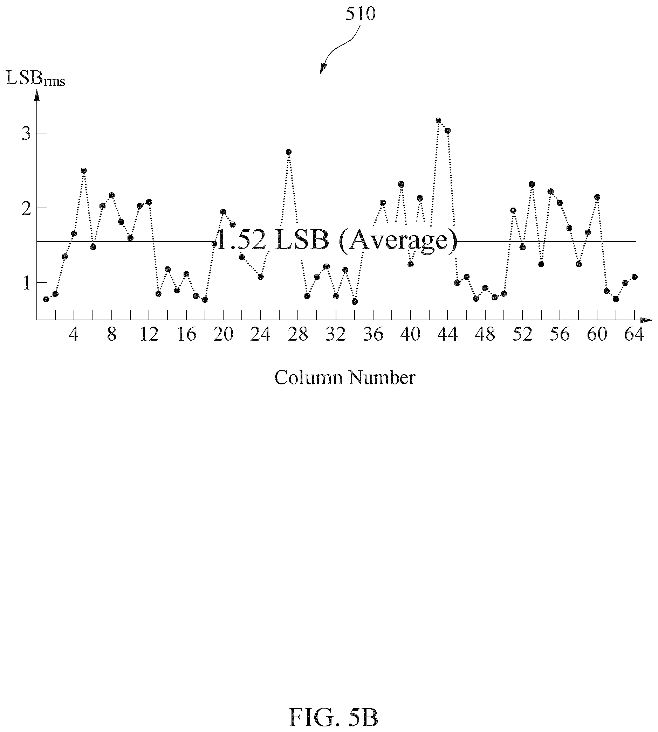

FIG. 5B is a diagram illustrating an occurrence of an error in a weight resistance value.

As described above, process variation during a semiconductor process may cause an error in a weight resistance value. Graph 510 shows a MAC calculation error that occurs when performing a MAC operation through a multi-bit operation device of a 64x64 array including a multi-bit cell where a weight resistance has not been calibrated. Graph 510 shows that a 0.8-3.2 LSBrms-level of a MAC calculation error occurs.

When the multi-bit operation device has a structure where 8 columns (e.g., columns 1-8, columns 9-16, ... columns 57-64) share an analog-to-digital converter (ADC) with one capacitor set and has programmed the same weight (e.g., the weight of columns 1-12 is the same as the weight of columns 13-24) in a 12-column unit, a different MAC calculation error by each column is only due to an error of a weight value. Accordingly, the multi-bit cell 100 according to one or more embodiments may accurately program weight values to improve the accuracy of calculations.

Referring to FIG. 5A again, the multi-bit cell 100 according to one or more embodiments may include the switch 160 of which one end is connected to the memory 110 and the opposite end to the end is connected to a bit line. In a weight calibration phase, the switch 160 may be on. When the switch 160 is on, a weight voltage VMAC may become the same as a voltage of the bit line. As described in an example in detail below, since a bit line according to one or more embodiments may be connected to a converter, the multi-bit cell according to one or more embodiments may convert a bit line voltage (e.g., a value that is the same as a weight voltage) which is analog data into digital data using the converter and the multi-bit cell according to one or more embodiments may accurately measure the bit line voltage. The multi-bit cell according to one or more embodiments may compare the weight voltage converted into the digital data with a target voltage and, through the comparison, the multi-bit cell according to one or more embodiments may determine whether there is an error. When it is determined that there is an error, the multi-bit cell according to one or more embodiments may calibrate (e.g., reprogram) the weight resistance stored in the memory 110.

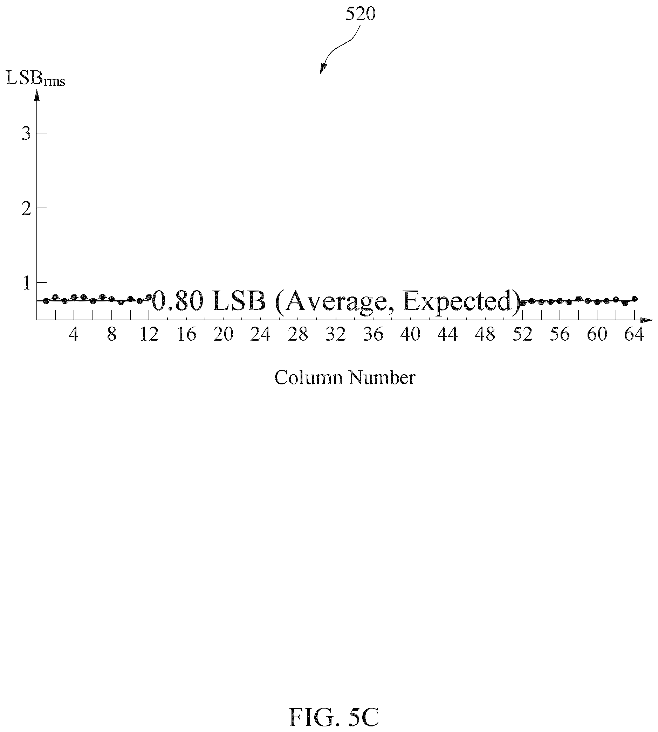

FIG. 5C is a diagram illustrating an effect of calibration according to one or more embodiments.

Referring to FIG. 5C, graph 520 shows a MAC calculation error that occurs when a weight value is calibrated in response to error occurrence after detecting whether there is an error in a weight resistance through a method according to one or more embodiments. Comparing graph 520 with graph 510, when performing the calibration according to one or more embodiments, an average operation error decreases to ½ and the maximum operation error decreases to ¼ from the graph 510 to the graph 520.

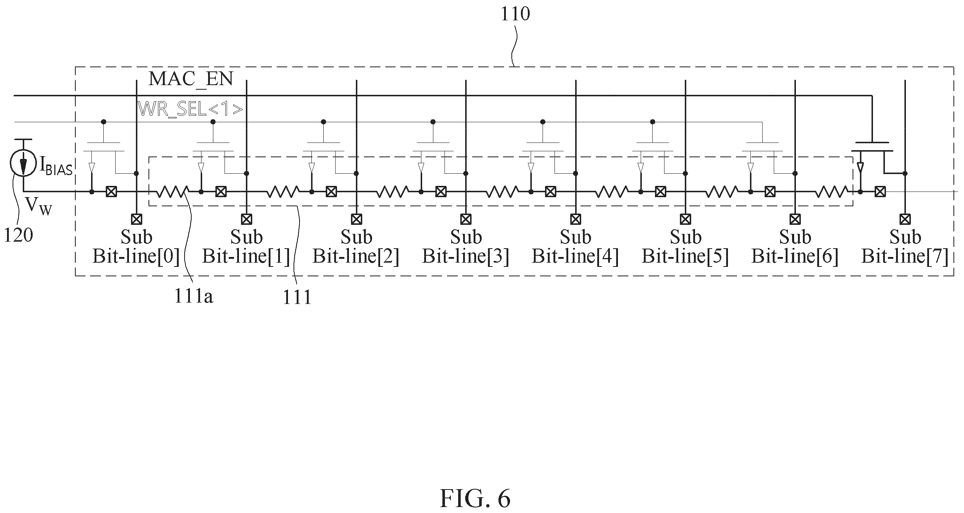

FIG. 6 is a circuit diagram illustrating a memory according to one or more embodiments.

Referring to FIG. 6, the memory may include a plurality of resistance elements 111.

The number of the resistance elements 111 of the memory 110 may correspond to the number of bits of a multi-bit weight. For example, when the multi-bit weight is an N-bit weight, the memory 110 may include 2N-1 resistance elements 111. The multi-bit weight in one or more embodiments of FIG. 6 is a 3-bit weight, and the memory 110 may include seven 23-1 resistance elements 111.

The resistance elements 111 may be connected to one another in series. A resistance element 111a may store two resistance values, and the memory 110 may represent 2N resistance values by using 2N-1 resistance elements 111 connected in series. The multi-bit cell 100 may control each of the resistance elements 111 to be on/off and may adjust a weight resistance. The multi-bit cell 100 may determine turning on/off each resistance element through a WR_SEL signal and may apply a current or a voltage to each resistance element through a Sub Bit-line[7:0] signal line.

For example, when the multi-bit weight corresponds to the weight resistance as shown in the example of Table 1, one resistance element may store 7 kΩ and the remaining resistance elements may store 1 kΩ, or each of the resistance elements may store 1 kΩ or 2 kΩ. The multibit cell 100 may control the resistance elements 111 connected in series to be on/off to store one weight resistance among 7kΩ, 8kΩ, 9kΩ, 10 kΩ, 11 kΩ, 12 kΩ, 13kΩ, and 14kΩ in the memory 110. Accordingly, the weight resistances from 7 kΩ to 14 kΩ in a 1 kΩ unit may be expressed from the memory 110.

The resistance element 111a may be a magnetic tunnel junction (MTJ) or MRAM. However, the foregoing examples are just examples, and elements that store a resistance and are controlled by a transistor may be a resistance element without limit.

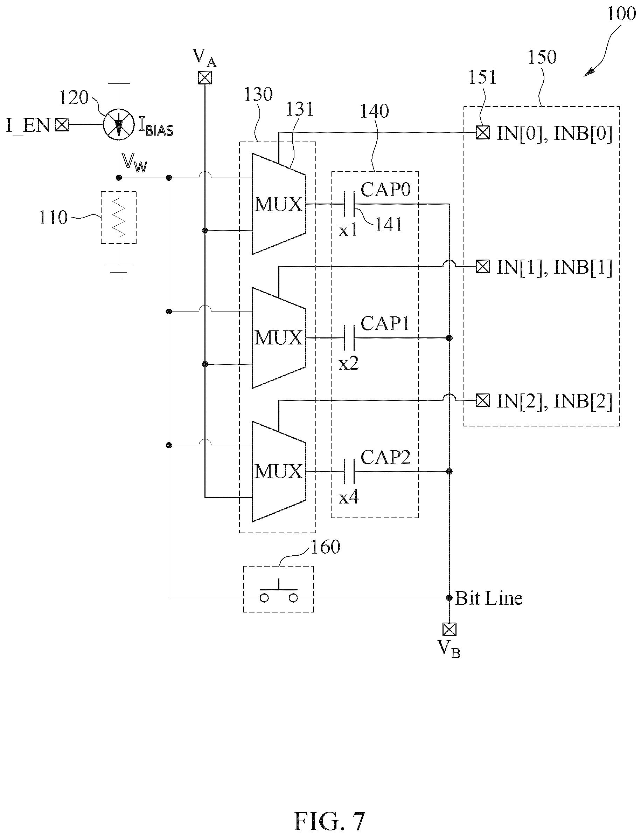

FIG. 7 is a circuit diagram illustrating a multi-bit cell according to one or more embodiments in which a first fixed voltage is output from all multiplexers.

Referring to FIG. 7, when a weight voltage is not used in the multi-bit cell 100, the current source 120 may be disabled, and only the first fixed weight may be applied to the plurality of multiplexers 130.

For example, when the multi-bit input 150 is 0, the weight voltage is not used in the multibit cell 100, and only the first fixed weight may be applied to the plurality of multiplexers 130. When all individual inputs 151 included in the multi-bit input 150 are 0, the multi-bit input 150 may be 0. When the multi-bit input 150 is a 3-bit input, the multi-bit input 150 that is 0 may be expressed by 3'b000. The plurality of multiplexers 130 may all receive an input of 0. The plurality of multiplexers 130 may output the first fixed voltage in response to the input of 0. Since the weight voltage is not relayed to the capacitors 140, the current source 120 may not need to operate to generate the weight voltage. Accordingly, the multi-bit cell 100 according to one or more embodiments, by controlling the current source 120 to be off, may reduce power consumption of the multi-bit cell 100. For example, the multi-bit cell 100 may control a current applied from the current source 120 to be 0 µA by using an I_EN signal, which is an enable signal that controls the current source 120.

However, all the plurality of multiplexers 130 may output the first fixed voltage in various cases other than the multi-bit input 150 being 0 depending on the structure and setting of the multi-bit cell 100. When the first fixed voltage is output from all the plurality of multiplexers 130, the weight voltage is not used in the multi-bit cell 100, and thus, the current source 120 may be controlled to be off and the multi-bit cell 100 according to one or more embodiments may reduce power consumption of the multi-bit cell 100.

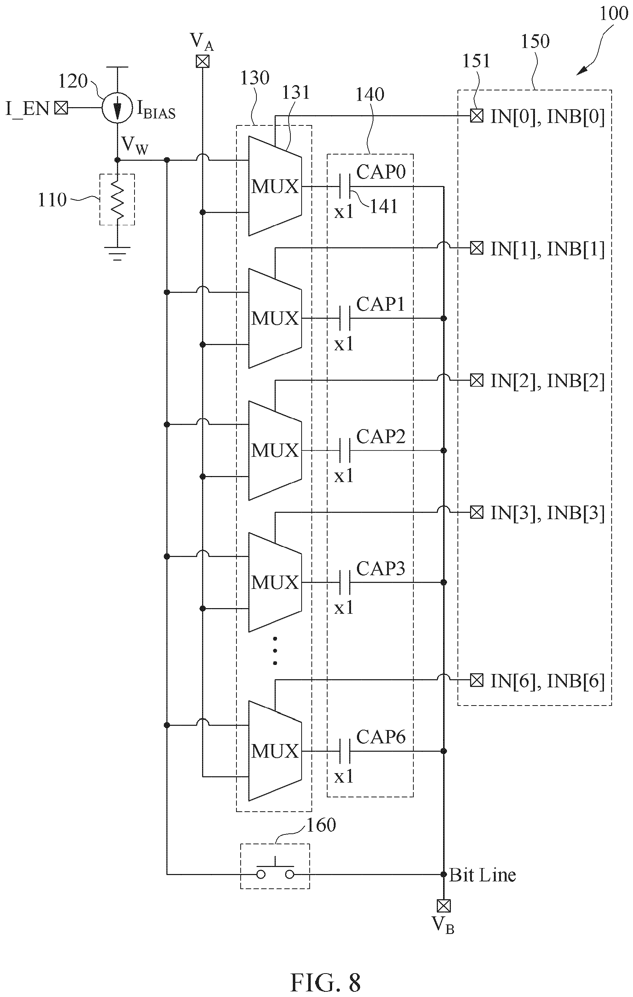

FIG. 8 is a circuit diagram illustrating a multi-bit cell according to one or more embodiments in which all capacitors store the same weight capacitance.

Referring to FIG. 8, the capacitors 140 may all store a weight capacitance of a unit capacitance.

The number of capacitors 140 of the multi-bit cell 100 may correspond to the number of bits of the multi-bit input 150. For example, the multi-bit cell 100 may include 2N-1 capacitors 140 for an N-bit multi-bit input 150. In this case, the weight capacitance stored in the capacitors 140 may all be the unit capacitance. The 2N-1 capacitors 140 may receive the multi-bit input 150 having values of 0 to 2N-1.

In the structure of one or more embodiments of FIG. 8, the multi-bit cell 100 may receive an input of various formats. For example, the multi-bit cell 100 may receive a thermometer code input, a binary input, a trinary input, or other inputs of various formats.

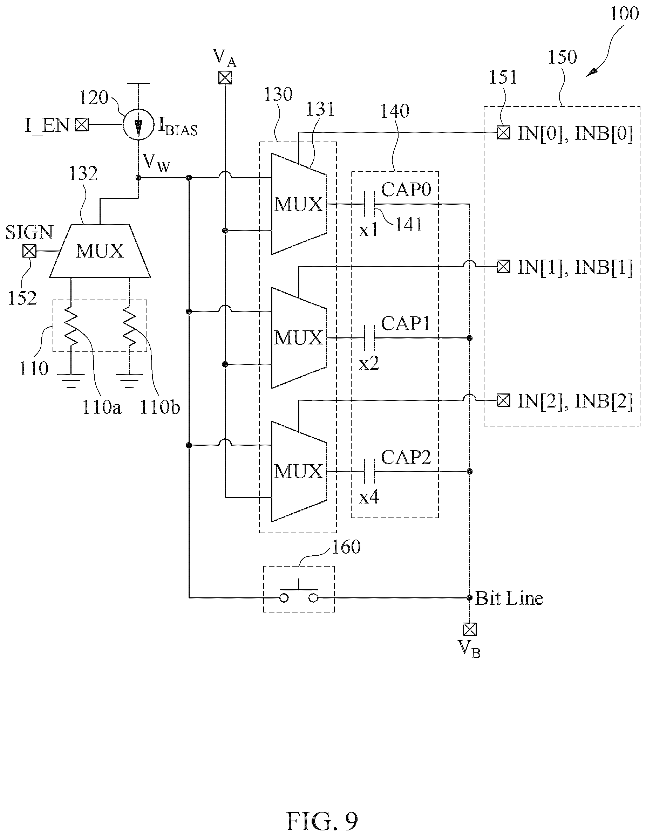

FIG. 9 is a circuit diagram illustrating a multi-bit cell according to one or more embodiments in which the multi-bit cell includes a plurality of memories.

Referring to FIG. 9, the memory 110 may include a first memory 110a and a second memory 110b, which store different weight resistances, and the multi-bit cell 100 may further include a sign multiplexer 132 that receives a sign input 152.

The weight resistances of the first memory 110a and the second memory 110b may have different signs of the same absolute value, different values of the same sign, or may be set variously. The sign multiplexer 132 may be connected to the first memory 110a and the second memory 110b. The multi-bit cell 100 may also receive the sign input 152 other than the multi-bit input 150 through the sign multiplexer 132. The sign multiplexer 132, based on the sign input 152, may determine one memory 110, of the first memory 110a and the second memory 110b, to which a current from the current source 120 is to be applied. The sign multiplexer 132 may connect the memory 110 that has been determined to receive the current to a line from the current source 120. The multi-bit cell 100, based on the sign input 152, may generate a weight voltage from the weight resistance stored in the determined memory 110.

The multi-bit cell 100, by including a plurality of memories 110 which store different weight resistances, may receive further various inputs and may perform operations on various weights. When the resistance weight of the first memory 110a is a positive number and the resistance weight of the second memory 110b is a negative number, the multi-bit cell 100 may receive a signed integer input and may perform an operation on the signed integer input.

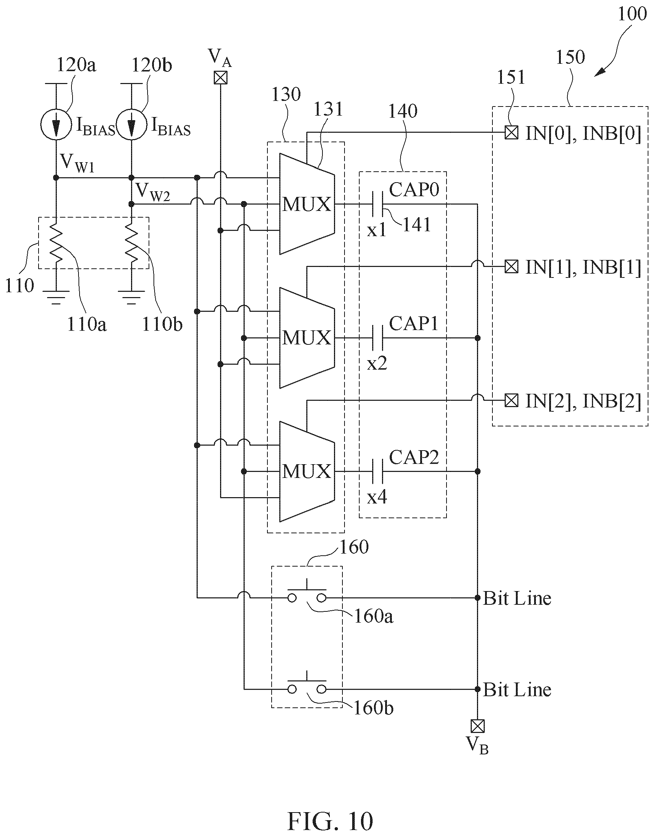

FIG. 10 is a circuit diagram illustrating a multi-bit cell according to an embodiment in which the multi-bit cell includes a plurality of memories.

Referring to FIG. 10, the memory 110 may include the first memory 110a and the second memory 110b which store different weight resistances, and the current source may include a first current source 120a that applies a current to the first memory 110a and a second current source 120b that applies a current to the second memory 110b. The multi-bit cell 100 may receive the multi-bit input 150 including a sign input.

The first memory 110a may store a first weight resistance and the second memory 110b may store a second weight resistance. The first weight resistance and the second weight resistance may have different signs of the same absolute value, different values of the same sign, or may be set variously.

The first current source 120a and the second current source 120b may apply the same size of current. The first current source 120a may apply a current to the first memory 110a to generate the first weight voltage and the second current source 120b may apply a current to the second memory 110b to generate the second weight voltage.

Each of the plurality of multiplexers 130 may output one signal of the first weight voltage, the second weight voltage, and the first fixed voltage, based on the multi-bit input 150 including a sign input. For example, the multiplexer 131 may output the first fixed voltage when the absolute value of an input is 0 and may determine one signal of the first weight voltage and the second weight voltage, based on the sign input, when the absolute value of the input is 1.

The multi-bit cell 100, by including a plurality of memories 110 which store different weight resistances, may receive further various inputs and may perform operations on various weights. When the resistance weight of the first memory 110a is a positive number and the resistance weight of the second memory 110b is a negative number, the multi-bit cell 100 may receive a signed integer input and may perform an operation on the signed integer input.

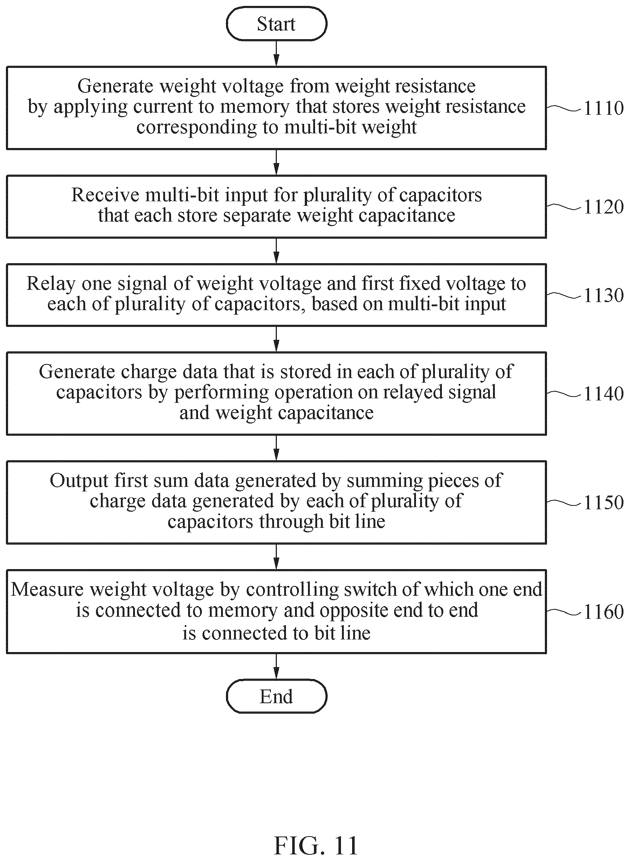

FIG. 11 is a flowchart illustrating an operating method of a multi-bit cell according to one or more embodiments. Operations 1110 to 1160 to be described hereinafter may be performed sequentially in the order and manner as shown and described below with reference to FIG. 11, but the order of one or more of the operations may be changed, one or more of the operations may be omitted, and/or two or more of the operations may be performed in parallel or simultaneously without departing from the spirit and scope of the example embodiments described herein.

Referring to FIG. 11, the operating method of the multi-bit cell may include the operations processed in a time series in the multi-bit cell illustrated in FIG. 4. Accordingly, even if the descriptions are omitted hereinafter, the descriptions of the multi-bit cell provided above with reference to FIGS. 4 to 10 may also apply to the method of FIG. 11.

In operation 1110, the multi-bit cell may generate a weight voltage from a weight resistance by applying a current to a memory that stores the weight resistance corresponding to a multi-bit weight.

The number, corresponding to the number of bits of the multi-bit weight, of resistance elements of the memory may connected to one another in series. The multi-bit cell may control each of the resistance elements to be on/off and may adjust the weight resistance.

The weight resistance may be set to increase linearly as the multi-bit weight increases.

In operation 1120, the multi-bit cell may receive a multi-bit input for a plurality of capacitors that each store a separate weight capacitance.

A value of each digit of the multi-bit input may be input to a multiplexer connected to a capacitor corresponding to the digit.

In operation 1130, the multi-bit cell may relay one signal of the weight voltage and a first fixed voltage to each of the plurality of capacitors, based on the multi-bit input.

A plurality of multiplexers may each receive an input of 1 or 0, and a multiplexer that receives 1 may output the weight voltage and a multiplexer that receives 0 may output the first fixed voltage among the plurality of multiplexers.

When the multi-bit input is 0, the plurality of multiplexers may all output the first fixed voltage and the multi-bit cell may control a current source to be off to reduce power consumption.

The size of a second fixed voltage relayed to the opposite end to one end of a capacitor to which the output signal is relayed may be the same as the size of the first fixed voltage and may be set such that a differential value of the second fixed voltage with the weight voltage is proportional to the multi-bit weight.

The multi-bit cell may include the capacitors of which the number corresponds to the number of bits of the multi-bit input, and each of the capacitors may store a weight capacitance of a value corresponding to each digit of the multi-bit input.

In operation 1140, the multi-bit cell may generate charge data that is stored in each of the plurality of capacitors by performing an operation on the relayed signal and the weight capacitance.

A capacitor that receives the first fixed voltage among the plurality of capacitors may have the same potential at both ends of the capacitor and may thus generate 0 C charge data when a 0 V voltage is applied to the capacitor.

The plurality of capacitors may receive the output signal at one end and receive a second fixed voltage at the opposite end to the end, may perform a differential operation on the second fixed voltage with respect to the output signal, and may generate the charge data by performing a multiplication operation on a differential value and the weight capacitance.

In operation 1150, the multi-bit cell may output first sum data generated by summing the charge data generated by each of the plurality of capacitors.

In one or more embodiments, the memory may include a first memory and a second memory which store different weight resistances. The multi-bit cell may further include a sign multiplexer that determines one memory to which a current is applied of the first memory and the second memory, based on a sign input. The multi-bit cell may generate the weight voltage from the weight resistance stored in the determined memory.

In another embodiment, the memory may include the first memory that stores a first weight resistance and the second memory that stores a second weight resistance. The current source may include a first current source and a second current source which apply the same size of current. The first current source may apply a current to the first memory to generate a first weight voltage and the second current source may apply a current to the second memory to generate a second weight voltage. Each of the plurality of multiplexers may output one signal of the first weight voltage, the second weight voltage, and the first fixed voltage, based on the multi-bit input including a sign input.

In operation 1160, the multi-bit cell may measure the weight voltage by controlling a switch. The end of the switch may be connected to the memory and the opposite end of the end of the switch may be connected to a bit line.

FIG. 12 is a block diagram illustrating a configuration of a multi-bit operation device according to one or more embodiments.

Referring to FIG. 12, a multi-bit operation device 1200 may include a plurality of multi-bit cells 200, a converter 300, and a weight calibration module 400. The converter 300 may include a comparator 310, a plurality of reference voltage cells 320, and a successive approximation register (SAR) logic 330. Only the components related to the present embodiments are shown in the multi-bit operation device 1200 illustrated in FIG. 12. Accordingly, it will be understood by one skilled in the art, with an understanding of the present disclosure, that the multi-bit operation device 1200 may further include general-purpose components other than the components illustrated in FIG. 12. The multi-bit cell 200 of FIG. 12 may correspond to the multi-bit cell 100 of FIG. 4.

The multi-bit operation device 1200 may include the plurality of multi-bit cells 200. The multi-bit operation device 1200 may generate second sum data by summing pieces of first sum data output from each of the multi-bit cells 200. The multi-bit operation device 1200 may output the second sum data and may input the second sum data to the converter 300. The converter 300 may convert the second sum data, which is analog data, into digital data.

The weight calibration module 400 may measure a weight voltage by controlling a switch. The term "module" used herein may be a unit including one or a combination of two or more of hardware, software, and firmware. The term "module" may be used interchangeably with other terms, for example, "unit", "logic", "logical block", "component", or "circuit". The "module" may be a minimum unit of an integrally formed component or part thereof. The "module" may be a minimum unit for performing one or more functions or part thereof. The "module" may be implemented mechanically or electronically. For example, the "module" may include at least one of an application-specific integrated circuit (ASIC) chip, a field-programmable gate array (FPGA), and/or a programmable-logic device for performing certain operations that are well known or to be developed in the future.

The weight calibration module 400 may control the switch to be in a first state (e.g., a on state), may input the weight voltage, which is analog data, to the converter, may convert the weight voltage into digital data, and may measure the weight voltage converted into the digital data. The weight calibration module 400 may compare the measured weight voltage with a target voltage and may determine whether there is an error. For example, when the difference between the measured weight voltage and the target voltage exceeds a predetermined threshold, the weight calibration module 400 may determine that the measured weight voltage has an error. The weight calibration module 400, when determining that there is an error, may calibrate the weight resistance to the target voltage.

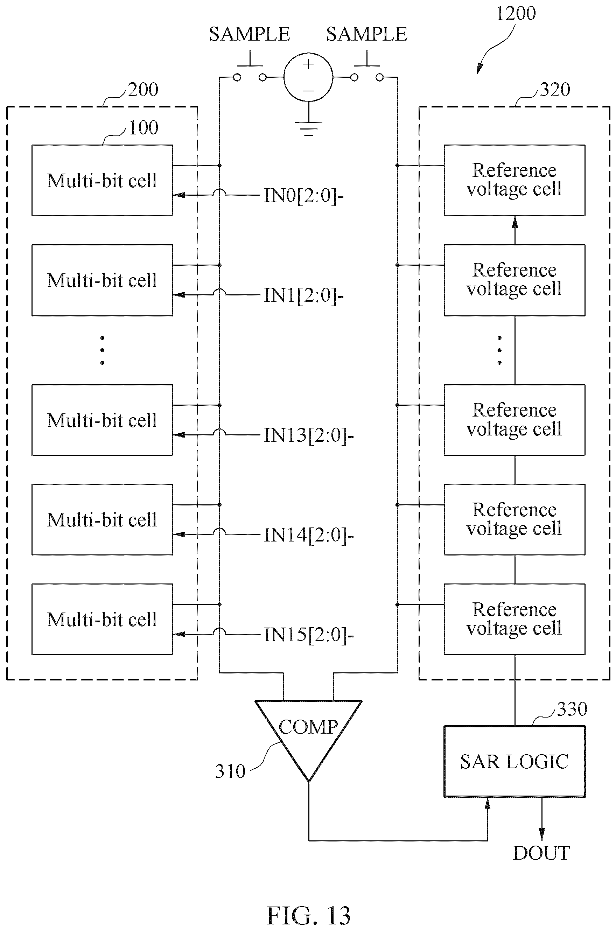

FIG. 13 is a circuit diagram illustrating a multi-bit operation device according to one or more embodiments.

Referring to FIG. 13, the plurality of multi-bit cells 200 are connected to one another in parallel, and the number of reference voltage cells 320 corresponding to the number of multi-bit cells 200 may also be connected to one another in parallel.

The multi-bit operation device 1200 may convert second sum data, which is analog data, into digital data. The multi-bit operation device 1200 may input the second sum data to the comparator 310 to convert the second sum data into digital data. The comparator 310 may store pieces of data into which ranges of a minimum value to a maximum value of the second sum data are divided by a certain number and may classify the second sum data based thereon. The comparator 310 may output data indicating a certain range to which a value of the second sum data among the ranges divided by the certain number belongs.

The SAR logic 330 may convert data that is relayed from the comparator 310 based on reference voltage data that is relayed from the reference voltage cells 320 into digital data. The SAR logic 330 may compare the size of the data relayed from the comparator 310 with the size of the reference voltage data and may perform digital conversion on the data. For example, the SAR logic 330 may perform the digital conversion on the data by repeating a method of maintaining a bit value when the data relayed from the comparator 310 is greater than the reference voltage data and deleting the bit value when the data relayed from the comparator 310 is less than the reference voltage data.

On the other hand, the circuit diagram of the multi-bit operation device illustrated in FIG. 13 is just an example, and the plurality of multi-bit cells 200 may be separated from the plurality of reference voltage cells 320. For example, the plurality of multi-bit cells 200 and the plurality of reference voltage cells 320 may receive signals from individual voltage sources or current sources, respectively.

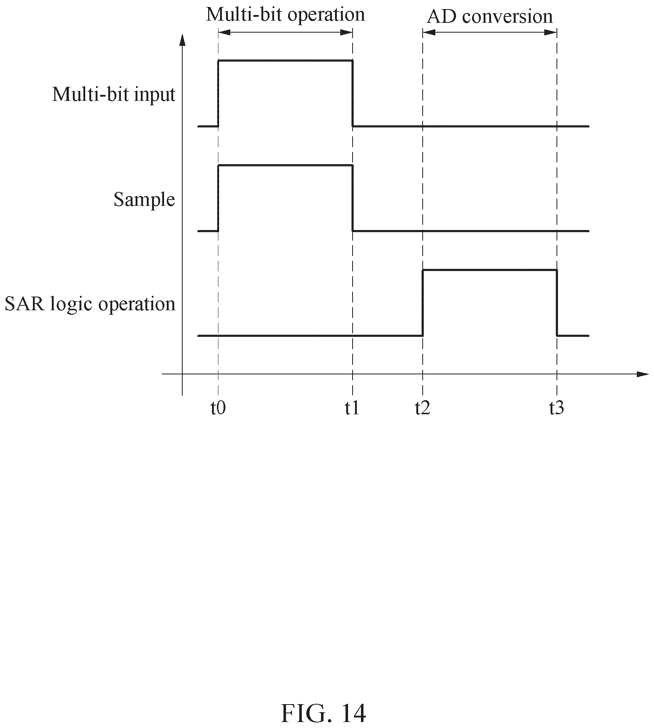

FIG. 14 is a graph illustrating a relationship between a multi-bit operation time and a digital conversion time, according to one or more embodiments.

As illustrated in FIG. 14, the multi-bit operation time may be separated from the digital conversion time, in which charge data, first sum data, and second sum data are generated through a multi-bit operation during the multi-bit operation time, and the second sum data is converted into digital data during the digital conversion time. A multi-bit operation device, by performing the multi-bit operation and digital conversion in different times, may enhance the efficiency of operation and power.

A sample voltage may be applied to a multi-bit cell and a multi-bit input may be received during the multi-bit operation time such that the multi-bit operation is performed in the multi-bit cell. When each of multi-bit cells outputs the first sum data, the multi-bit operation device may sum pieces of the first sum data and may generate the second sum data.

The sample voltage applied to the multi-bit cell is off during the digital conversion time and a converter including an SAR logic may operate. The converter may convert the second sum data, which is analog data, into digital data.

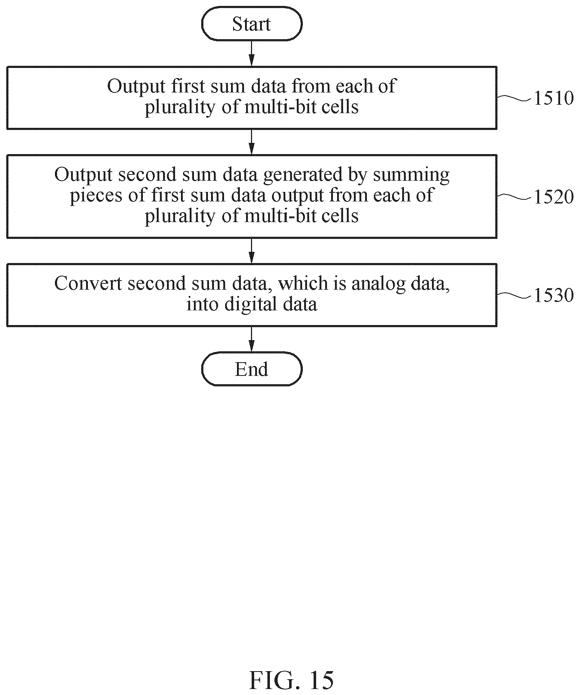

FIG. 15 is a flowchart illustrating an operating method of a multi-bit operation device according to one or more embodiments. Operations 1510 to 1530 to be described hereinafter may be performed sequentially in the order and manner as shown and described below with reference to FIG. 15, but the order of one or more of the operations may be changed, one or more of the operations may be omitted, and/or two or more of the operations may be performed in parallel or simultaneously without departing from the spirit and scope of the example embodiments described herein.

Referring to FIG. 15, the operating method of the multi-bit operation device may include the operations processed in a time series in the multi-bit operation device illustrated in FIG. 12. Accordingly, even if the descriptions are omitted hereinafter, the descriptions of the multi-bit operation device provided above with reference to FIGS. 12 to 14 may also apply to the method of FIG. 15.

In operation 1510, each of a plurality of multi-bit cells may output first sum data.

In operation 1520, the multi-bit operation device may output second sum data generated by summing pieces of the first sum data output from each of the plurality of multi-bit cells.

In operation 1530, the multi-bit operation device may convert the second sum data, which is analog data, into digital data.

The multi-bit operation device may include a converter that converts second sum data, which is analog data, into digital data. The converter may include a plurality of reference voltage cells and an SAR logic.

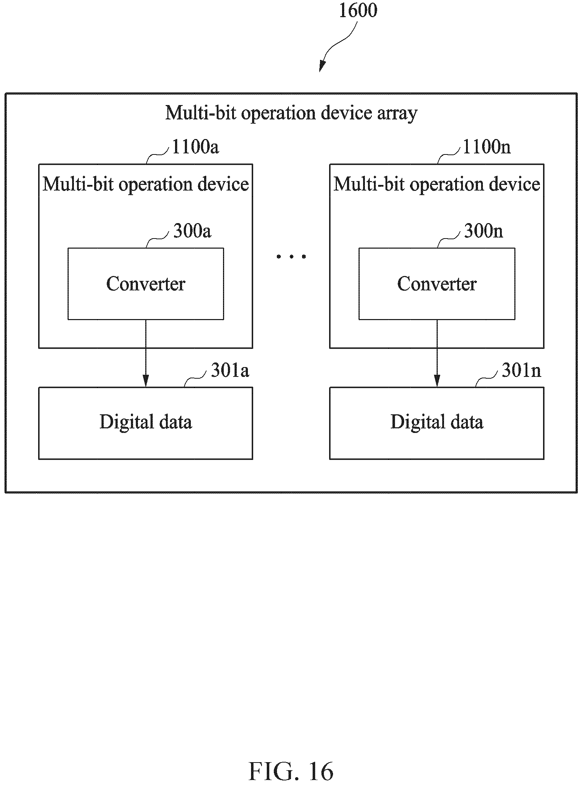

FIG. 16 is a block diagram illustrating a configuration of a multi-bit operation device array according to one or more embodiments.

Referring to FIG. 16, a multi-bit operation device array 1600 may include a plurality of multi-bit operation devices 1100a to 1100n. Each multi-bit operation device 1100a may include a converter 300a, and the converter 300a may output digital data 301a. Only the components related to the present embodiments are shown in the multi-bit operation device array 1600 illustrated in FIG. 16. Accordingly, it is obvious to those skilled in the art that the multi-bit operation device array 1600 may further include general-purpose components other than the components illustrated in FIG. 16. The multi-bit operation device 1100a and the converter 300a of FIG. 16 may respectively correspond to the multi-bit operation device 1100 and the converter 300 of FIG. 12.

Each of the multi-bit operation devices 1100a to 1100n may generate and output digital data by converting second sum data output from multi-bit cells. The multi-bit operation device array 1600 may output the final operation result of an input to the multi-bit operation device array 1600 by combining pieces of digital data 301a to 301n output respectively from the multi-bit operation devices 1100a to 1100n. The multi-bit operation device array 1600 may correspond to, for example, the neural network 20 of FIG. 2 including multiple layers including an input layer and an output layer.

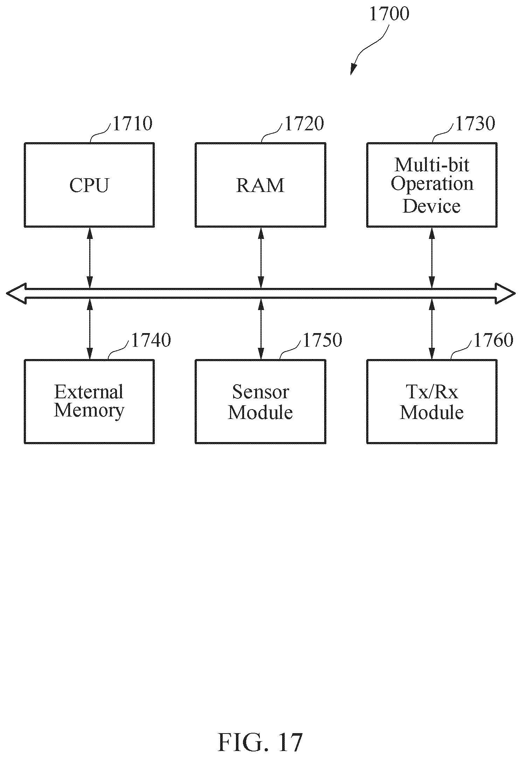

FIG. 17 is a block diagram illustrating an electronic system according to one or more embodiments.

Referring to FIG. 17, an electronic system 1700 may analyze input data based on a multibit operation device 1730 and extract valid information and may determine a situation based on the extracted information or control components of an electronic device to which the electronic system 1700 is mounted. For example, the electronic system 1700 may be applied to a drone, a robot apparatus, such as an advanced drivers assistance system (ADAS), a smart TV, a smartphone, a medical device, a mobile device, a video display device, a measurement device, and an Internet of Things (IoT) device and in addition thereto, may be mounted to various types of electronic devices.

In addition to the multi-bit operation device 1730, the electronic system 1700 may include a central processing unit (CPU) 1710 (e.g., one or more processors), RAM 1720, an external memory 1740 (e.g., one or more memories), a sensor module 1750, and a communication module (or a Tx/Rx module) 1760. Additionally, the electronic system 1700 may further include an input/output module, a security module, a power control device, and the like. A portion of hardware components of the electronic system 1700 may be mounted to a semiconductor chip. The multi-bit operation device 1730 may be an implementation of the multi-bit operation device described above with reference to the drawings in an on-chip type or may be an apparatus including the multi-bit operation device described above with reference to the drawings as a part thereof.

The CPU 1710 controls the overall operation of the electronic system 1700. The CPU 1710 may include a single processor core (single core) or a plurality of processor cores (multicore). The CPU 1710 processes or executes programs and/or data stored in the external memory 1740. For example, the external memory 1740 may include a non-transitory computer-readable storage medium storing instructions that, when executed by the CPU 1710, configure the CPU 1710 to perform any one, any combination, or all of the operations and/or methods described above with reference to FIGS. 1 through 16. The CPU 1710 may control the functions of the multibit operation device 1730 by executing the programs stored in the external memory 1740. The functions of the CPU 1710 may be implemented in a graphics processing unit (GPU), an application processor (AP), and/or the like.

The RAM 1720 may store programs, data, or instructions temporarily. For example, the programs and/or the data stored in the memory 1740 may be temporarily stored in the RAM 1720 according to control by the CPU 1710 or booting code. The RAM 1720 may be implemented as a memory device, such as dynamic RAM (DRAM) or static RAM (SRAM).

The multi-bit operation device 1730 may perform a multi-bit operation based on received input data and may generate an information signal based on a performing result. The multi-bit operation device 1730 may be used as a neuromorphic device or a neural network device. A neural network may include a convolutional neural network (CNN), a recurrent neural network (RNN), a deep belief network (DBN), a restricted Boltzmann machine (RBM), and the like, but examples are not limited thereto. The multi-bit operation device 1730 may be a hardware accelerator dedicated for the neural network. On the other hand, the multi-bit operation device 1730 may be applied to various systems that implement an operation for a multi-bit input and a multi-bit weight, besides the neuromorphic or neural network.

The information signal may include one of various types of recognition signals, such as a voice recognition signal, an object recognition signal, a video recognition signal, and a biological information recognition signal. For example, the multi-bit operation device 1730 may receive, as input data, frame data included in a video stream and may generate a recognition signal about an object included in an image represented by the frame data. The multi-bit operation device 1730 may receive various types of input data depending on the type or function of the electronic device to which the electronic system 1700 is mounted and may generate a recognition signal according to the input data.

The external memory 1740 may be a storage configured to store data and may store an operating system (OS), various types of programs, and various types of data. The external memory 1740 may include a volatile memory and/or a non-volatile memory. The non-volatile memory may include read-only memory (ROM), programmable ROM (PROM), erasable programmable ROM (EPROM), electrically erasable ROM (EEPROM), flash memory, phase-change RAM (PRAM), MRAM, resistive RAM (RRAM), ferroelectric RAM (FeRAM), and the like. The volatile memory may include DRAM, SRAM, synchronous DRAM (SDRAM), PRAM, MRAM, RRAM, FeRAM, and/or the like. The external memory 1740 may include, for example, hard disk drives (HDDs), solid state drives (SSDs), compact flash (CF) memory, secure digital (SD) memory, micro-SD memory, mini-SD memory, extreme digital (xD) memory, and/or memory sticks.

The sensor module 1750 may collect information around the electronic device to which the electronic system 1700 is mounted. The sensor module 1750 may sense or receive a signal (e.g., an image signal, a voice signal, a magnetic signal, a biosignal, a touch signal, etc.) from the outside of the electronic device and may convert the sensed or received signal into data. In this case, the sensor module 1750 may be various types of sensing devices, such as a microphone, an imaging device, an image sensor, a light detection and ranging (LiDAR) sensor, an ultrasonic sensor, an infrared sensor, a biosensor, or a touch sensor.

The sensor module 1750 may provide the data to the multi-bit operation device 1730 as input data. For example, the sensor module 1750 may include an image sensor, may generate a video stream by capturing an external environment of the electronic device, and may sequentially provide consecutive data frames of the video stream as input data to the multi-bit operation device 1730. However, examples are not limited thereto, and the sensor module 1750 may provide various types of data to the multi-bit operation device 1730.

The communication module 1760 may include various types of wired or wireless interfaces configured to communicate with an external apparatus. For example, the communication module 1760 may include a wired local area network (LAN), a wireless local area network (WLAN), such as wireless fidelity (Wi-Fi), a wireless personal area network (WPAN), such as Bluetooth, a wireless universal serial bus (USB), ZigBee, near field communication (NFC), radio-frequency identification (RFID), power line communication (PLC), a communication interface accessible to a mobile cellular network, such as 3rd generation (3G), 4th generation (4G), long term evolution (LTE), or 5th generation (5G), and the like.

The electronic system 1700 may further include a user interface device, such as a touch panel, a key, or a button, other than a memory device that stores and executes program data, a permanent storage, such as a disk drive, and a communication port that communicates with an external apparatus. The methods implemented in a software module or an algorithm may be computer-readable code or program instructions that may be executed in a processor, which may be stored in a computer-readable storage medium.

On the other hand, the operating methods described with reference to FIGS. 11 and 15 may be stored in a storage medium that is readable by a computer storing one or more programs including instructions for executing the operating methods. Examples of non-transitory computer-readable media include magnetic media such as hard disks, floppy disks, and magnetic tape; optical media such as CD-ROM discs and DVDs; magneto-optical media such as optical discs; and hardware devices that are specially configured to store and perform program instructions, such as ROM, RAM, flash memory, and the like. Examples of program instructions include both machine code, such as produced by a compiler, and files containing higher-level code that may be executed by the computer using an interpreter.

The multi-bit operation devices, multi-bit cells, memories, resistance elements, current sources, multiplexers, capacitors, switches, converters, weight calibration modules, comparators, reference voltage cells, SAR logics, multi-bit operation device arrays, electronic systems, CPUs, RAMs, external memories, sensor modules, Tx/Rx modules, multi-bit operation device 30, multibit cell 100, memory 110, first memory 110a, second memory 110b, resistance elements 111, resistance element 111a, current source 120, first current source 120a, second current source 120b, multiplexers 130, multiplexer 131, capacitors 140, capacitor 141, switch 160, multi-bit operation device 1200, multi-bit cells 200, converter 300, weight calibration module 400, comparator 310, reference voltage cells 320, SAR logic 330, multi-bit operation device array 1600, multi-bit operation devices 1100a to 1100n, converters 300a to 300n, electronic system 1700, CPU 1710, RAM 1720, multi-bit operation device 1730, external memory 1740, sensor module 1750, and Tx/Rx module 1760 described herein, including descriptions with respect to respect to FIGS. 1-17, are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in, and discussed with respect to, FIGS. 1-17 that perform the operations described in this application are performed by computing hardware, for example, by one or more processors or computers, implemented as described above implementing instructions (e.g., computer or processor/processing device readable instructions) or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks , and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the disclosure is specified by the claims.

## Claims

1. A multi-bit cell comprising:
a memory (110) configured to store a weight resistance corresponding to a multi-bit weight;
a current source (120) configured to apply current to the memory (110) such that a weight voltage is generated from the weight resistance;
a plurality of multiplexers (130, 131) connected to one another in parallel and connected to the memory (110) in series and each configured to output a signal of one of the weight voltage and a first fixed voltage, based on a multi-bit input;
a plurality of capacitors (140, 141) connected respectively to the plurality of multiplexers (130, 131) and each configured to store a separate weight capacitance and generate charge data by performing an operation on the output signal and the weight capacitance; and
a bit line configured to output first sum data generated by summing pieces of charge data generated by each of the plurality of capacitors (140, 141);
**characterised by**
a switch (160) of which an end is connected to the memory (110) and an opposite end to the end is connected to the bit line,
wherein, in a weight calibration phase, the switch (160) being in a first state, the multi-bit cell (100, 200) is configured to connect a voltage of the bit line to be equal to the weight voltage, achieve a digital data of the bit line voltage that is the same as the weight voltage, compare the weight voltage converted into the digital data with a target voltage, and, when a result of the comparison indicates an error, calibrate the weight resistance to the target voltage.

2. The multi-bit cell of claim 1, wherein
the memory (110) comprises resistance elements (111) of which the number corresponds to the number of bits of the multi-bit weight and that are connected to one another in series, and
the multi-bit cell (100, 200) is configured to control each of the resistance elements (111) to be on/off and adjust the weight resistance.

3. The multi-bit cell of claim 1 or 2, wherein the plurality of multiplexers (130, 131) each receives an input of 1 or 0, and
a multiplexer that receives 1 is configured to output the weight voltage and a multiplexer that receives 0 is configured to output the first fixed voltage among the plurality of multiplexers (130, 131).

4. The multi-bit cell of one of claims 1 to 3, wherein,
in response to the first fixed voltage being output from all the plurality of multiplexers (130, 131), the multi-bit cell (100, 200) is configured to control the current source (120) to be off and reduce power consumption.

5. The multi-bit cell of one of claims 1 to 4, wherein
the size of a second fixed voltage that is relayed to an opposite end to an end of a capacitor to which the output signal is relayed is the same as the size of the first fixed voltage, and
a capacitor that receives the first fixed voltage among the plurality of capacitors (140, 141) and has the same potential at both ends of the capacitor is configured to generate 0 C charge data in response to a 0 V voltage being applied to the capacitor,
wherein the weight resistance is set to linearly increase as the multi-bit weight increases, and the size of the second fixed voltage is set such that a differential value from the weight voltage is proportional to the multi-bit weight.

6. The multi-bit cell of one of claims 1 to 5, wherein
the multi-bit cell (100, 200) comprises the plurality of capacitors (140, 141) of which the number corresponds to the number of bits of the multi-bit input, and
each of the plurality of capacitors (140, 141) is configured to store a weight capacitance of a value corresponding to each digit of the multi-bit input, and
wherein a value of each digit of the multi-bit input is input to a multiplexer connected to a capacitor corresponding to the digit.

7. The multi-bit cell of one of claims 1 to 6, wherein the plurality of capacitors (140, 141) is further configured to
receive the output signal at one end and receive a second fixed voltage at an opposite end to the end, perform a differential operation on the second fixed voltage with respect to the output signal, and generate the charge data by performing a multiplication operation on a value of the differential operation and the weight capacitance.

8. The multi-bit cell of one of claims 1 to 7, wherein
the memory (110) comprises a first memory (110a) and a second memory (110b) configured to store different weight resistances,
the multi-bit cell (100, 200) further comprises a sign multiplexer configured to determine, based on a sign input, one memory to which the current is to be applied between the first memory (110a) and the second memory (110b), and
a weight voltage is generated from a weight resistance stored in the determined memory.

9. The multi-bit cell of one of claims 1 to 8, wherein
the memory (110) comprises a first memory (110a) configured to store a first weight resistance and a second memory (110b) configured to store a second weight resistance,
the current source (120) comprises a first current source configured to apply current to the first memory (110a) to generate a first weight voltage and a second current source configured to apply current to the second memory (110b) to generate a second weight voltage, and
each of the plurality of multiplexers (130, 131) is configured to output one signal of the first weight voltage, the second weight voltage, and the first fixed voltage, based on the multibit input comprising a sign input.

10. A multi-bit operation device comprising:
a plurality of multi-bit cells (100, 200) each comprising the multi-bit cell (100, 200) of one of claims 1 to 9; and
a converter (300) configured to convert second sum data into digital data, wherein the second sum data is generated by summing pieces of first sum data output from each of the plurality of multi-bit cells (100, 200).

11. The multi-bit operation device of claim 10, further comprising a weight calibration module (400) configured to measure the weight voltage by controlling the switch (160), and one or more of:
wherein the weight calibration module (400) is further configured to control the switch (160) to be in a first state, input the weight voltage, which is analog data, to the converter (300), to convert the weight voltage into digital data, and measure the weight voltage converted into the digital data,
wherein the weight calibration module (400) is further configured to compare the measured weight voltage with a target voltage and determine whether there is an error, and
wherein the weight calibration module (400) is further configured to, in response to determining that there is the error, calibrate the weight resistance to the target voltage.

12. A multi-bit operation method comprising:
generating (1110) a weight voltage from a weight resistance by applying current to a memory (110) in which the weight resistance corresponding to a multi-bit weight is stored;
receiving (1120) a multi-bit input for a plurality of capacitors (140, 141) each configured to store a separate weight capacitance;
relaying (1130) one signal of the weight voltage and a first fixed voltage to each of the plurality of capacitors (140, 141), based on the multi-bit input;
generating (1140) charge data that is stored in each of the plurality of capacitors (140, 141) by performing an operation on the relayed signal and the weight capacitance; and
outputting (1150) first sum data generated by summing pieces of charge data generated by each of the plurality of capacitors (140, 141) through a bit line;
**characterised by**
controlling (1160) a switch (160) of which an end is connected to the memory (110) and an opposite end to the end is connected to the bit line and measuring the weight voltage, wherein the measuring the weight voltage comprises controlling the switch (160) to be in a first state, inputting the weight voltage, which is analog data, to a converter (300), converting the weight voltage into digital data, and measuring the weight voltage converted into the digital data, comparing the measured weight voltage with a target voltage and determining whether there is an error, and, in response to determining that there is the error, calibrating the weight resistance to the target voltage.

## Patentansprüche

1. Mehrbitzelle, umfassend:
einen Speicher (110), ausgebildet zum Speichern eines Gewichtswiderstands entsprechend einem Mehrbitgewicht;
eine Stromquelle (120), ausgebildet zum Zuführen von Strom zum Speicher (110), so dass eine Gewichtsspannung aus dem Gewichtswiderstand erzeugt wird;
eine Vielzahl von Multiplexern (130, 131), die parallel miteinander verbunden sind und in Reihe mit dem Speicher (110) verbunden sind und jeweils zum Ausgeben eines Signals der Gewichtsspannung oder einer ersten festen Spannung, basierend auf einer Mehrbiteingabe, ausgebildet sind.
eine Vielzahl von Kondensatoren (140, 141), die jeweils mit der Vielzahl von Multiplexern (130, 131) verbunden sind und jeweils zum Speichern einer separaten Gewichtskapazitanz und Erzeugen von Ladungsdaten durch Durchführen einer Operation am Ausgangssignal und der Gewichtskapazitanz ausgebildet sind; und
eine Bitleitung, ausgebildet zum Ausgeben von ersten Summendaten, die durch Summieren von Ladungsdatenteilen erzeugt werden, die von jedem der Vielzahl von Kondensatoren (140, 141) erzeugt werden;
**gekennzeichnet durch**
einen Schalter (160), von dem ein Ende mit dem Speicher (110) verbunden ist und ein dem Ende gegenüberliegendes Ende mit der Bitleitung verbunden ist,
wobei in einer Gewichtskalibrierungsphase, während sich der Schalter (160) in einem ersten Zustand befindet, die Mehrbitzelle (100, 200) zum Verbinden einer Spannung der Bitleitung gleich der Gewichtsspannung, Erzielen von digitalen Daten der Bitleitungsspannung, welche die gleiche ist wie die Gewichtsspannung, Vergleichen der in die digitalen Daten umgewandelte Gewichtsspannung mit einer Sollspannung und, wenn ein Ergebnis des Vergleichs einen Fehler angibt, Kalibrieren des Gewichtswiderstands auf die Sollspannung ausgebildet ist.

2. Mehrbitzelle nach Anspruch 1, wobei
der Speicher (110) Widerstandselemente (111) umfasst, deren Anzahl der Anzahl von Bits des Mehrbitgewichts entspricht und die in Reihe miteinander verbunden sind, und
die Mehrbitzelle (100, 200) zum Ein-/Ausschalten von jedem der Widerstandselemente (111) und Anpassen des Gewichtswiderstands ausgebildet ist.

3. Mehrbitzelle nach Anspruch 1 oder 2, wobei die Vielzahl von Multiplexern (130, 131)jeweils eine Eingabe von 1 oder 0 empfängt, und
ein Multiplexer, der 1 empfängt, zum Ausgeben der Gewichtsspannung ausgebildet ist und ein Multiplexer, der 0 empfängt, zum Ausgeben der ersten festen Spannung von der Vielzahl von Multiplexern (130, 131) ausgebildet ist.

4. Mehrbitzelle nach einem der Ansprüche 1 bis 3, wobei,
als Reaktion darauf, dass von allen der Vielzahl von Multiplexern (130, 131) die erste feste Spannung ausgegeben wird, die Mehrbitzelle (100, 200) zum Ausschalten der Stromquelle (120) und Reduzieren des Stromverbrauchs ausgebildet ist.

5. Mehrbitzelle nach einem der Ansprüche 1 bis 4, wobei
die Größe einer zweiten festen Spannung, die zu einem gegenüberliegenden Ende zu einem eines Kondensators, zu dem das Ausgangssignal weitergeleitet wird, weitergeleitet wird, die gleiche ist wie die Größe der ersten festen Spannung, und
ein Kondensator, der die erste feste Spannung von der Vielzahl von Kondensatoren (140, 141) empfängt und das gleiche Potential an beiden Enden des Kondensators aufweist, zum Erzeugen von 0-C-Ladungsdaten als Reaktion auf das Zuführen einer 0-V-Spannung zum Kondensator ausgebildet ist,
wobei der Gewichtswiderstand so festgelegt wird, dass er linear zunimmt, wenn das Mehrbitgewicht zunimmt, und die Größe der zweiten festen Spannung so festgelegt wird, dass ein Differentialwert von der Gewichtsspannung proportional zum Mehrbitgewicht ist.

6. Mehrbitzelle nach einem der Ansprüche 1 bis 5, wobei
die Mehrbitzelle (100, 200) die Vielzahl von Kondensatoren (140, 141) umfasst, deren Anzahl der Anzahl von Bits der Mehrbiteingabe entspricht, und
jeder der Vielzahl von Kondensatoren (140, 141) zum Speichern einer Gewichtskapazitanz eines Wertes entsprechend jeder Ziffer der Mehrbiteingabe ausgebildet ist, und
wobei ein Wert jeder Ziffer der Mehrbiteingabe an einem Multiplexer eingegeben wird, der mit einem der Ziffer entsprechenden Kondensator verbunden ist.

7. Mehrbitzelle nach einem der Ansprüche 1 bis 6, wobei die Vielzahl von Kondensatoren (140, 141) ferner zum Empfangen des Ausgangssignals an einem Ende und Empfangen einer zweiten festen Spannung an einem gegenüberliegenden Ende zum Ende, Durchführen einer Differentialoperation an der zweiten festen Spannung in Bezug auf das Ausgangssignal und Erzeugen der Ladungsdaten durch Durchführen einer Multiplikationsoperation an einem Wert der Differentialoperation und der Gewichtskapazitanz ausgebildet ist.

8. Mehrbitzelle nach einem der Ansprüche 1 bis 7, wobei
der Speicher (110) einen ersten Speicher (110a) und einen zweiten Speicher (110b), ausgebildet zum Speichern von verschiedenen Gewichtswiderständen, umfasst,
die Mehrbitzelle (100, 200) ferner einen Vorzeichenmultiplexer umfasst, ausgebildet zum Bestimmen, basierend auf einer Vorzeicheneingabe, von einem Speicher, dem der Strom zugeführt werden soll, zwischen dem ersten Speicher (110a) und dem zweiten Speicher (110b), und
eine Gewichtsspannung aus einem im bestimmten Speicher gespeicherten Gewichtswiderstand erzeugt wird.

9. Mehrbitzelle nach einem der Ansprüche 1 bis 8, wobei
der Speicher (110) einen ersten Speicher (110a), ausgebildet zum Speichern eines ersten Gewichtswiderstands, und einen zweiten Speicher (110b), ausgebildet zum Speichern eines zweiten Gewichtswiderstands, umfasst,
die Stromquelle (120) eine erste Stromquelle, ausgebildet zum Zuführen von Strom zum ersten Speicher (110a) zum Erzeugen einer ersten Gewichtsspannung, und eine zweite Stromquelle, ausgebildet zum Zuführen von Strom zum zweiten Speicher (110b) zum Erzeugen einer zweiten Gewichtsspannung umfasst, und
jeder der Vielzahl von Multiplexern (130, 131) zum Ausgeben von einem Signal der ersten Gewichtsspannung, der zweiten Gewichtsspannung und der ersten festen Spannung, basierend auf der Mehrbiteingabe, umfassend eine Vorzeicheneingabe, ausgebildet ist.

10. Mehrbitoperations-Vorrichtung, umfassend:
eine Vielzahl von Mehrbitzellen (100, 200), jeweils umfassend die Mehrbitzelle (100, 200) nach einem der Ansprüche 1 bis 9; und
einen Wandler (300), ausgebildet zum Umwandeln von zweiten Summendaten in digitale Daten, wobei die zweiten Summendaten durch Summierten von Teilen von ersten Summendaten, die von jeder der Vielzahl von Mehrbitzellen (100, 200) ausgegeben werden, erzeugt werden.

11. Mehrbitoperations-Vorrichtung nach Anspruch 10, ferner umfassend ein Gewichtskalibrierungsmodul (400), ausgebildet zum Messen der Gewichtsspannung durch Steuern des Schalters (160), und:
wobei das Gewichtskalibrierungsmodul (400) ferner zum Steuern des Schalters (160), so dass er sich in einem ersten Zustand befindet, Zuführen der Gewichtsspannung, die aus analogen Daten besteht, zum Wandler (300), um die Gewichtsspannung in digitale Daten umzuwandeln, und Messen der in die digitalen Daten umgewandelten Gewichtsspannung ausgebildet ist, oder/und
wobei das Gewichtskalibrierungsmodul (400) ferner zum Vergleichen der gemessenen Gewichtsspannung mit einer Sollspannung und Bestimmen, ob ein Fehler vorliegt, ausgebildet ist, oder/und wobei das Gewichtskalibrierungsmodul (400) ferner zum, als Reaktion auf das Bestimmen, dass ein Fehler vorliegt, Kalibrieren des Gewichtswiderstands auf die Sollspannung ausgebildet ist.

12. Mehrbitoperations-Verfahren, umfassend:
Erzeugen (1110) einer Gewichtungsspannung aus einem Gewichtswiderstand durch Zuführen von Strom zu einem Speicher (110), in dem der einem Mehrbitgewicht entsprechende Gewichtswiderstand gespeichert ist; Empfangen (1120) einer Mehrbiteingabe für eine Vielzahl von Kondensatoren (140, 141), die jeweils zum Speichern einer separaten Gewichtskapazitanz ausgebildet sind;
Weiterleiten (1130) eines Signals der Gewichtungsspannung und einer ersten festen Spannung an jeden der Vielzahl von Kondensatoren (140, 141) basierend auf der Mehrbiteingabe;
Erzeugen (1140) von Ladungsdaten, die in jedem der Vielzahl Kondensatoren (140, 141) gespeichert werden, durch Durchführen einer Operation am weitergeleiteten Signal und an der Gewichtskapazitanz; und
Ausgeben (1150) von ersten Summendaten, die durch Summieren von Ladungsdatenteilen erzeugt werden, die von jedem der Vielzahl von Kondensatoren (140, 141) erzeugt werden, durch eine Bitleitung;
**gekennzeichnet durch** das Steuern (1160) eines Schalters (160), von dem ein Ende mit dem Speicher (110) verbunden ist und ein dem Ende gegenüberliegendes Ende mit der Bitleitung verbunden ist, und das Messen der Gewichtsspannung,
wobei das Messen der Gewichtsspannung das Steuern des Schalters (160), so dass sich dieser in einem ersten Zustand befindet, das Zuführen der Gewichtsspannung, die aus analogen Daten besteht, zu einem Wandler (300), das Umwandeln der Gewichtsspannung in digitale Daten und das Messen der in die digitalen Daten umgewandelten Gewichtsspannung, das Vergleichen der gemessenen Gewichtsspannung mit einer Sollspannung und das Bestimmen, ob ein Fehler vorliegt, und, als Reaktion auf das Bestimmen, dass ein Fehler vorliegt, das Kalibrieren des Gewichtswiderstands auf die Sollspannung umfasst.

## Revendications

1. Cellule multibit comprenant :
une mémoire (110) configurée pour stocker une résistance de poids correspondant à un poids multibit ;
une source de courant (120) configurée pour appliquer un courant à la mémoire (110) de sorte qu'une tension de poids soit générée à partir de la résistance de poids ;
une pluralité de multiplexeurs (130, 131) connectés les uns aux autres en parallèle et connectés en série à la mémoire (110) et dont chacun est configuré pour délivrer en sortie un signal constitué de l'une parmi la tension de poids et une première tension fixe, en fonction d'une entrée multibit ;
une pluralité de condensateurs (140, 141) respectivement connectés à la pluralité de multiplexeurs (130, 131) et dont chacun est configuré pour stocker une capacité de poids distincte et générer des données de charge en effectuant une opération sur le signal de sortie et la capacité de poids ; et
une ligne de bits configurée pour délivrer en sortie des premières données de somme générées en faisant la somme de données de charge élémentaires générées par chacun de la pluralité de condensateurs (140, 141) ;
**caractérisée par**
un commutateur (160) dont une extrémité est connectée à la mémoire (110) et une extrémité opposée à ladite extrémité est connectée à la ligne de bits,
dans laquelle, dans une phase d'étalonnage de poids, le commutateur (160) étant dans un premier état, la cellule multibit (100, 200) est configurée pour connecter une tension de la ligne de bits pour qu'elle soit égale à la tension de poids, obtenir des données numériques de la tension de la ligne de bits qui est égale à la tension de poids, comparer la tension de poids convertie en données numériques avec une tension cible, et, quand un résultat de la comparaison indique une erreur, étalonner la résistance de poids sur la tension cible.

2. Cellule multibit selon la revendication 1, dans laquelle
la mémoire (110) comprend des éléments de résistance (111) dont le nombre correspond au nombre de bits du poids multibit et qui sont connectées les uns aux autres en série,
et
la cellule multibit (100, 200) est configurée pour commander chacun des éléments de résistance (111) dans un état activé (on)/désactivé (off) et régler la résistance de poids.

3. Cellule multibit selon la revendication 1 ou 2, dans laquelle la pluralité de multiplexeurs (130, 131) reçoivent chacun une entrée égale à 1 ou 0, et
un multiplexeur qui reçoit 1 est configuré pour délivrer en sortie la tension de poids, et un multiplexeur qui reçoit 0 est configuré pour délivrer en sortie la première tension fixe parmi la pluralité de multiplexeurs (130, 131).

4. Cellule multibit selon l'une des revendications 1 à 3, dans laquelle,
en réponse à la délivrance en sortie de la première tension fixe par la totalité de la pluralité de multiplexeurs (130,131), la cellule multibit (100, 200) est configurée pour commander la source de courant (20) pour qu'elle soit désactivée et réduire la consommation électrique.

5. Cellule multibit selon l'une des revendications 1 à 4, dans laquelle
l'amplitude d'une seconde tension fixe qui est acheminée vers une extrémité opposée d'une extrémité d'un condensateur vers lequel est acheminé le signal de sortie est identique à l'amplitude de la première tension fixe, et
un condensateur qui reçoit la première tension fixe parmi la pluralité de condensateurs (140, 141) et qui a le même potentiel à ses deux extrémités est configuré pour générer des données de charge de 0 C en réponse à l'application d'une tension de 0 V au condensateur,
dans laquelle la résistance de poids est définie pour augmenter linéairement lorsque le poids multibit augmente, et l'amplitude de la seconde tension fixe est définie de telle sorte qu'une valeur différentielle par rapport à la tension de poids soit proportionnelle au poids multibit.

6. Cellule multibit selon l'une des revendications 1 à 5, dans laquelle
la cellule multibit (100, 200) comprend la pluralité de condensateurs (140, 141) dont le nombre correspond au nombre de bits de l'entrée multibit, et
chacun de la pluralité de condensateurs (140, 141) est configuré pour stocker une capacité de poids d'une valeur correspondant à chaque chiffre de l'entrée multibit, et
dans laquelle une valeur de chaque chiffre de l'entrée multibit est entrée dans le multiplexeur connecté à un condensateur correspondant au chiffre.

7. Cellule multibit selon l'une des revendications 1 à 6, dans laquelle la pluralité de condensateurs (140, 141) est en outre configurée pour
recevoir le signal de sortie à une extrémité et recevoir une seconde tension fixe à une extrémité opposée à ladite extrémité, effectuer une opération différentielle sur la seconde tension fixe par rapport au signal de sortie, et générer les données de charge en effectuant une opération de multiplication sur une valeur de l'opération différentielle et la capacité de poids.

8. Cellule multibit selon l'une des revendications 1 à 7, dans laquelle
la mémoire (110) comprend une première mémoire (110a) et une seconde mémoire (110b) configurées pour stocker des résistances de poids différentes,
la cellule multibit (100, 200) comprend en outre un multiplexeur de signe configuré pour déterminer, sur la base d'une entrée de signe, une mémoire à laquelle le courant doit être appliqué entre la première mémoire (110a) et la seconde mémoire (110b), et
une tension de poids est générée à partir d'une résistance de poids stockée dans la mémoire déterminée.

9. Cellule multibit selon l'une des revendications 1 à 8, dans laquelle
la mémoire (110) comprend une première mémoire (110a) configurée pour stocker une première résistance de poids et une seconde mémoire (110b) configurée pour stocker une seconde résistance de poids,
la source de courant (120) comprend une première source de courant configurée pour appliquer un courant à la première mémoire (110a) afin de générer une première tension de poids et une seconde source de courant configurée pour appliquer un courant à la seconde mémoire (110b) afin de générer une seconde tension, et
chacun de la pluralité de multiplexeurs (130, 131) est configuré pour délivrer en sortie un signal de la première tension de poids, de la seconde tension de poids et de la première tension fixe, sur la base de l'entrée multibit comprenant une entrée de signe.

10. Dispositif d'opération multibit comprenant :
une pluralité de cellules multibit (100, 200) comprenant chacune la cellule multibit (100, 200) selon l'une des revendications 1 à 9 ; et
un convertisseur (300) configuré pour convertir des secondes données de somme en données numériques, dans lequel les secondes données de somme sont générées en faisant la somme de premières données de somme élémentaires délivrées en sortie par chacune de la pluralité de cellules multibit (100, 200).

11. Dispositif de fonctionnement multibit selon la revendication 10, comprenant en outre un module d'étalonnage du poids (400) configuré pour mesurer la tension de poids par commande du commutateur (160), et effectuer l'une ou plusieurs des actions suivantes :
dans lequel le module d'étalonnage du poids (400) est en outre configuré pour commander au commutateur (160) d'être dans un premier état, entrer la tension de poids, qui est une donnée analogique, dans le convertisseur (300), afin de convertir la tension de poids en donnée numérique, et mesurer la tension de poids convertie en donnée numérique,
dans lequel le module d'étalonnage du poids (400) est en outre configuré pour comparer la tension de poids mesurée à une tension cible et déterminer l'existence d'une erreur, et
dans lequel le module d'étalonnage du poids (400) est en outre configuré, en réponse à la détermination de l'existence de l'erreur, pour étalonner la résistance de poids sur la tension cible.

12. Procédé de fonctionnement multibit comprenant :
la génération (1110) d'une tension de poids à partir d'une résistance de poids par application d'un courant à une mémoire (110) dans laquelle est stockée la résistance de poids correspondant à un poids multibit ;
la réception (1120) d'une entrée multibit pour une pluralité de condensateurs (140, 141) dont chacun est configuré pour stocker une capacité de poids distincte ;
l'acheminement (1130) d'un signal de la tension de poids et d'une première tension fixe vers chacun de la pluralité de condensateurs (140, 141), en fonction de l'entrée multibit ;
la génération (1140) d'une donnée de charge qui est stockée dans chacun de la pluralité de condensateurs (140,141) en effectuant une opération sur le signal acheminé et la capacité de poids ;
et
la délivrance en sortie (1150) de premières données de somme générées en faisant la somme de données de charge élémentaires générées par chacun de la pluralité de condensateurs (140, 141), par le biais d'une ligne de bits,
**caractérisé par**
la commande (1160) d'un commutateur (160) dont une extrémité est connectée à la mémoire (110) et une extrémité opposée à ladite extrémité est connectée à la ligne de bits et la mesure de la tension de poids,
dans lequel la mesure de la tension de poids comprend la commande du commutateur (160) pour qu'il soit dans un premier état, l'entrée de la tension de poids, qui est une donnée analogique, dans un convertisseur (300), la conversion de la tension de poids en donnée numérique, et la mesure de la tension de poids convertie en donnée numérique, la comparaison de la tension de poids mesurée à une tension cible et la détermination de l'existence d'une erreur, et en réponse à la détermination de l'existence d'une erreur, l'étalonnage de la résistance de poids sur la tension cible.
